(19) Europäisches Patentamt
European Patent Office
Office européen des brevets

(11) **EP 4 375 347 A1**

(12) **EUROPEAN PATENT APPLICATION**

(43) Date of publication:
**29.05.2024 Bulletin 2024/22**

(21) Application number: **23211781.2**

(22) Date of filing: **23.11.2023**

(51) International Patent Classification (IPC):
**C09K 11/02** (2006.01)    **C09K 11/56** (2006.01)
**C09K 11/62** (2006.01)    **C09K 11/64** (2006.01)
**H01L 33/50** (2010.01)    **H10K 50/115** (2023.01)

(52) Cooperative Patent Classification (CPC):
**C09K 11/621; C09K 11/02; C09K 11/565;
C09K 11/641; H01L 33/502; H10K 50/115**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.11.2022 KR 20220159786**

(71) Applicants:
• **Samsung Electronics Co., Ltd.
Suwon-si, Gyeonggi-do 16677 (KR)**
• **Commissariat à l'Energie Atomique et aux
Energies
Alternatives
75015 Paris (FR)**
• **Centre National de la Recherche Scientifique
75016 Paris (FR)**

• **Université Grenoble Alpes
38400 Saint Martin d'Hères (FR)**

(72) Inventors:
• **WON, Yuho
16678 Suwon-si (KR)**
• **KIM, Yongwook
16678 Suwon-si (KR)**
• **REISS, Peter
38054-CEDEX-9 Grenoble (FR)**
• **SAHA, Avijit
38054-CEDEX-9 Grenoble (FR)**
• **YADAV, Ranjana
38054-CEDEX-9 Grenoble (FR)**

(74) Representative: **Elkington and Fife LLP
Prospect House
8 Pembroke Road
Sevenoaks, Kent TN13 1XR (GB)**

(54) **NANOCRYSTAL PARTICLES AND PRODUCTION METHOD THEREOF**

(57)    A nanocrystal particle includes a Group III-VI compound including gallium and sulfur, wherein the nanocrystal particle is configured to emit a first light, a maximum emission peak of the first light is in a wavelength range of greater than or equal to about 300 nanometers and less than or equal to about 485 nanometers, and in the nanocrystal particle, a molar ratio of sulfur to gallium is greater than or equal to 1.8.

FIG. 1A

EP 4 375 347 A1

**Description**

**FIELD OF THE INVENTION**

The present disclosure relates to a crystalline nanoparticle, a production method thereof, and a device including the same.

**BACKGROUND OF THE INVENTION**

A crystalline particle having a nanoscale size (e.g., including compound semiconductors) may exhibit luminescence. For example, light emission from this particle may occur when an electron in an excited state resulting from light excitation or an applied voltage transitions from a conduction band to a valence band.

The crystalline nanoparticle may emit light in a desired wavelength region by controlling its particle size, composition, or both. The nanoparticle may be used in a light emitting device (e.g., an electroluminescent device or a photoluminescent device) and a display device including the same.

**SUMMARY OF THE INVENTION**

Example embodiments are directed to nanocrystal particle(s) (e.g., capable of emitting blue light and low toxicity, for example, being environmentally friendly).

Example embodiments are directed to a method for producing the nanocrystal particles.

Example embodiments are directed to a light emitting device or an electronic device including the aforementioned nanoparticles.

In an embodiment, a nanocrystal particle includes a Group III-VI compound. The Group III-VI compound includes a Group 13 element including gallium and a Group 16 element including sulfur. The nanocrystal particle is configured to emit a first light, and a maximum emission peak of the first light exists in a wavelength range of greater than or equal to about 300 nanometers (nm) and less than or equal to about 485 nm. The nanocrystal particles may have an absolute quantum efficiency of greater than or equal to about 26%. The maximum emission peak may have a full width at half maximum of less than or equal to about 70 nm, for example, when analyzed by photoluminescence spectroscopy.

In an aspect, the nanocrystal particle includes:

a Group III-VI compound including gallium and sulfur,
wherein the nanocrystal particle is configured to emit a first light,
a maximum emission peak of the first light is in a wavelength range of greater than or equal to about 300 nanometers and less than or equal to about 485 nanometers,
an absolute quantum efficiency of the nanocrystal particle is greater than or equal to about 26%, and
a full width at half maximum of the maximum emission peak of the first light is greater than or equal to about 10 nanometers and less than or equal to about 70 nanometers.

In an aspect, the nanocrystal particle includes:

a Group III-VI compound including gallium and sulfur,
wherein the nanocrystal particle is configured to emit a first light and has a size or an average size (hereinafter, "size") of greater than or equal to about 1 nanometer and less than or equal to about 12 nanometers,
a maximum emission peak wavelength of the first light is in a range of greater than or equal to about 300 nanometers and less than or equal to about 485 nanometers,
an absolute quantum efficiency of the nanocrystal particle is greater than or equal to about 26% and less than or equal to about 100%, and
a full width at half maximum of the maximum emission peak of the first light is greater than or equal to about 10 nanometers and less than or equal to about 70 nanometers, for example, when analyzed by photoluminescence spectroscopy.

In the nanocrystal particle of an embodiment, a molar ratio of sulfur to gallium may be greater than or equal to about 1.2, or greater than or equal to about 1.8 and less than or equal to about 4.5.

In an embodiment, the nanocrystal particle may further include zinc.

In an embodiment, the nanocrystal particle may not include cadmium, lead, mercury, or a combination thereof.

The Group 13 element may further include indium, thallium, or a combination thereof. The Group 16 element may further include selenium, tellurium, or a combination thereof.

The Group III-VI compound may include a gallium sulfide, for example, $Ga_2S_3$. The gallium sulfide may include $Ga_2S_3$, an indium gallium sulfide, or a combination thereof.

The nanocrystal particle may further include zinc, aluminum, or a combination thereof.

The maximum emission peak wavelength of the first light may be greater than or equal to about 375 nm, greater than or equal to about 385 nm, greater than or equal to about 395 nm, or greater than or equal to about 400 nm. The maximum emission peak wavelength of the first light may be less than or equal to about 475 nm, or less than or equal to about 465 nm.

The absolute quantum efficiency may be greater than or equal to about 30% or greater than or equal to about 40%.

The maximum emission peak of the first light may have a full width at half maximum of less than or equal to about 50 nm, or less than or equal to about 30 nm.

In the nanocrystal particles, gallium may be predominantly present inside the particle. In the nanocrystal particles, a gallium content inside the particle may be greater than the outside of the particle. In the nanocrystal particles, gallium may exhibit a concentration gradient that decreases from the center to the surface of the particle.

In an embodiment, the nanocrystal particle may have a core-shell structure having a core and a shell disposed on the core. A gallium content of the core may be greater than a gallium content in the shell. The shell may or may not include gallium.

The shell may further include zinc, aluminum, or a combination thereof.

The shell may include a Group II-VI compound (e.g., zinc chalcogenide).

The shell may include a metal oxide.

The shell may include zinc sulfide, aluminum oxide, or a combination thereof.

The shell may have a multi-layered shell structure including a first shell layer disposed on the core (or directly on the core) and a second shell layer disposed on the first shell layer.

The first shell layer may include zinc sulfide. The second shell layer may include aluminum oxide. The second shell layer may include a surface of the nanocrystal particles.

In the nanocrystal particle, a molar ratio of sulfur to gallium (S/Ga) may be greater than or equal to about 1.5, greater than or equal to about 1.8, or greater than or equal to about 1.85.

In the nanocrystal particles, the molar ratio of the sulfur to the gallium may be less than or equal to about 3.5, or less than or equal to about 3.

The nanocrystal particle may further include zinc, in the nanocrystal particle, a molar ratio of the zinc to the gallium may be greater than or equal to about 0.05, greater than or equal to about 0.1 and less than or equal to about 1.5, or less than or equal to about 1.

The nanocrystal particle may have a first peak at a diffraction angle, 2theta, in the range of about 15 degrees to about 23 degrees when analyzed by X-ray diffraction using $CuK\alpha$ radiation. The first peak may exist at a 2 theta of about 18 degrees to about 22 degrees. The first peak may have a full width at half maximum of greater than or equal to about 0.5 degree, greater than or equal to about 1 degree, or greater than or equal to about 1.5 degrees. The first peak may have a full width at half maximum of less than or equal to about 10 degrees, or less than or equal to about 8 degrees.

The nanocrystal particle may have a second peak at a 2 theta in the range of about 25 degrees to about 32 degrees as confirmed by X-ray diffraction analysis. The nanocrystal particle may have a third peak at 2theta in the range of about 33 degrees to about 39 degrees as confirmed by X-ray diffraction analysis.

The nanocrystal particle may exhibit, in the UV absorption spectrum,

a valley depth (VD) defined by the following equation of greater than or equal to 0.2:

$$1 - (Abs_{valley} / Abs_{first}) = VD$$

wherein Absfirst is an absorption at the first absorption peak and $Abs_{valley}$ is an absorption at the lowest point of the valley adjacent to the first absorption peak.

The nanocrystal particle may have bandgap energy (e.g., calculated from UV absorption spectrum) of greater than or equal to about 2.6 electronvolts (eV), greater than or equal to about 3 eV, or greater than or equal to about 3.3 eV, and less than or equal to about 3.5 eV.

The nanocrystal particle may exhibit an average decay time or life-span (tau average) of greater than or equal to about 0.5 nanosecond (ns), greater than or equal to about 0.9 ns, or greater than or equal to about 1 ns when analyzed by time-resolved photoluminescence spectroscopy.

The nanocrystal particle may have an average decay time or life-span (tau average) of less than or equal to about 50 ns, less than or equal to about 10 ns, or less than or equal to about 5 ns when analyzed by time-resolved photoluminescence spectroscopy.

The nanocrystal particle may have a quantum efficiency maintenance of greater than or equal to about 90% of the initial quantum efficiency after being left in the atmosphere for 7.5 days.

The nanocrystal particle may have a size or an average size of greater than or equal to about 1 nm and less than or equal to about 12 nm.

In an embodiment, a method for producing the nanocrystal particle includes contacting (e.g., mixing) a gallium precursor, a sulfur precursor, and an additive in an organic solvent, and heating the obtained mixture to a reaction temperature of greater than about 250 °C to form gallium sulfide (e.g., to provide a reaction system including gallium sulfide and produce the nanocrystal particle),

wherein a content of the sulfur precursor per 1 mole of the gallium precursor is greater than or equal to about 4 moles. The content of the sulfur precursor per 1 mole of the gallium precursor may be greater than or equal to about 5 moles, greater than or equal to about 6 moles or greater than or equal to about 7 moles. The content of the sulfur precursor per 1 mole of the gallium precursor may be less than or equal to about 50 moles, or less than or equal to about 20 moles.

In an aspect, the method of producing the nanocrystal particle includes:

contacting a gallium precursor, a sulfur precursor, and an additive in an organic solvent to provide a reaction system including gallium sulfide and produce the nanocrystal particle,
wherein a content of the sulfur precursor per 1 mole of the gallium precursor is greater than or equal to about 4 moles and less than or equal to about 50 moles,
wherein the additive includes a phosphine compound (e.g., having at least one, two, or three C1-C30 hydrocarbon group such as an alkyl group, alkenyl group, or alkynyl group);
wherein the nanocrystal particle includes
a Group III-VI compound including gallium and sulfur,
wherein the nanocrystal particle is configured to emit a first light,
a maximum emission peak wavelength of the first light is in a range of greater than or equal to about 300 nanometers and less than or equal to about 485 nanometers,
an absolute quantum efficiency of the nanocrystal particle is greater than or equal to about 26%, and
a full width at half maximum of the maximum emission peak of the first light is greater than or equal to about 10 nanometers and less than or equal to about 70 nanometers,
when analyzed by photoluminescence spectroscopy.

The sulfur precursor may include a sulfur powder.

The additive may include a compound represented by $R_3P$, wherein R is each independently hydrogen or a substituted or unsubstituted C1 to C30 hydrocarbon group, and at least one R is a substituted or unsubstituted C1 to C30 hydrocarbon group.

The organic solvent may include a primary amine, a secondary amine, a tertiary amine, a nitrogen-containing heterocyclic compound, a substituted or unsubstituted $C_{4-50}$ aliphatic hydrocarbon solvent, a substituted or unsubstituted $C_{6-50}$ aromatic hydrocarbon solvent, a substituted or unsubstituted phosphine solvent, a substituted or unsubstituted phosphine oxide solvent, an aromatic ether solvent, or a combination thereof.

The method may further include adding a zinc precursor, an aluminum precursor, or a combination thereof, optionally together with an organic ligand, to the reaction system including gallium sulfide.

The organic ligand may include $RCOOH$, $RNH_2$, $R_2NH$, $R_3N$, $RSH$, $RH_2PO$, $R_2HPO$, $R_3PO$, $RH_2P$, $R_2HP$, $R_3P$, $ROH$, $RCOOR'$, $RPO(OH)_2$, $R_2POOH$, or a combination thereof, wherein R and R' may each independently include a substituted or unsubstituted $C_{1-40}$ aliphatic hydrocarbon group, or a substituted or unsubstituted $C_{6-40}$ aromatic hydrocarbon group, or a combination thereof.

An embodiment is directed to an electronic device (e.g., a display device) including the nanocrystal particle described herein.

An embodiment is directed to a light emitting device including the nanocrystal particle described herein.

In an embodiment, the electroluminescent device includes a first electrode and a second electrode spaced apart from each other; and

a light emitting layer between the first electrode and the second electrode;
wherein the light emitting layer includes the nanocrystal particle described herein.

The light emitting device may further include a hole auxiliary layer between the light emitting layer and the first electrode.

The light emitting device may further include an electron auxiliary layer between the light emitting layer and the second electrode.

The light emitting device may further include a hole auxiliary layer between the light emitting layer and the first electrode, and further include an electron auxiliary layer between the light emitting layer and the second electrode.

In an embodiment, the hole auxiliary layer may include a hole transport layer including an organic polymer compound.

In an embodiment, the hole auxiliary layer and the electron auxiliary layer may include zinc magnesium metal oxide nanoparticles.

In an embodiment, the photoluminescent device includes a light source (e.g., a light emitting panel) and a color conversion element (e.g., a color conversion panel), wherein the light source is configured to provide incident light to the color conversion element and the color conversion element includes the nanocrystal particles.

The color conversion element may include a nanocrystal particle composite. The composite may include a matrix (e.g., a polymer matrix) and the nanocrystal particle dispersed within the matrix.

In another embodiment, the display device may include the aforementioned nanocrystal particles or a light emitting device.

In an embodiment, the nanocrystal particle containing a compound that includes gallium and sulfur (e.g., gallium sulfide) may emit light in a desired wavelength range, such as a blue light, with an improved efficiency and a narrower full width at half maximum. In an embodiment, the nanocrystal particle may exhibit improved stability (chemical stability). In an embodiment, the nanocrystal particle may exhibit low levels of toxicity.

## BRIEF DESCRIPTION OF THE DRAWINGS

FIG. 1A is a schematic cross-sectional view of an electronic device (e.g., a display device) including nanocrystal particles according to an embodiment.

FIG. 1B is a schematic cross-sectional view of an electronic device including nanocrystal particles according to an embodiment.

FIG. 1C is a schematic cross-sectional view of an electronic device including nanocrystal particles according to an embodiment.

FIG. 2A schematically shows an exploded view of a device according to an embodiment.

FIG. 2B schematically shows a cross-section of a device according to an embodiment.

FIG. 2C schematically shows a cross-section of a device according to an embodiment.

FIG. 3 is a graph of photoluminescence (PL) intensity (arbitrary units, a.u.) vs. wavelength (nanometers, nm) showing PL spectrum of the nanocrystal particle produced in Example 2.

FIGS. 4A-4D are each a graph of intensity (a.u.) vs. binding energy (electronvolts, eV) of Ga2p, S2p, Zn2p, and Al2p, respectively, and show the high-resolution X-ray photoelectron spectroscopy (XPS) results of the nanocrystal particle ($Ga_2S_3$/ZnS/$Al_2O_3$) produced in Example 2.

FIG. 5 is a graph of intensity (a.u.) vs. diffraction angle $2\theta$ (degree, °) and shows an X-ray diffraction spectrum of the nanocrystal particle produced in the examples.

FIG. 6 is a graph of variation of photoluminescence quantum efficiency (PLQY) vs. time (days) and shows the results of Example 3.

## DETAILED DESCRIPTION OF THE EMBODIMENTS

Hereinafter, various embodiments of the present disclosure will be described in detail with reference to the accompanying drawings so that those of ordinary skill in the art may easily implement the present disclosure. The present disclosure may be implemented in various different forms and is not limited to the embodiments described herein.

In order to clearly explain the present invention, parts irrelevant to the description are omitted, and the same reference numerals are assigned to the same or similar elements throughout the specification.

The size and thickness of each constituent element as shown in the drawings are randomly indicated for better understanding and ease of description, and this disclosure is not necessarily limited to as shown. In the drawings, the thickness of layers, films, panels, regions, etc., are exaggerated for clarity. In addition, in the drawings, for better understanding and ease of description, the thickness of some layers and areas is exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being disposed on or below the object portion, and does not necessarily mean being disposed on the upper side of the object portion based on a gravitational direction.

In addition, unless explicitly described to the contrary, the word "comprise," and variations such as "comprises" or "comprising," will be understood to imply the inclusion of stated elements but not the exclusion of any other elements. It will be further understood that the terms "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

In addition, "on a cross-section" herein means when a cross-section in which the target portion is cut (e.g., substantially perpendicular to the bottom surface) is viewed from the side.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Further, the singular includes the plural unless mentioned otherwise. The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. Thus, reference to "an" element in a claim followed by reference to "the" element is inclusive of one element and a plurality of the elements. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10% or 5% of the stated value. All ranges disclosed herein are inclusive of the endpoints, and the endpoints are independently combinable with each other (e.g., ranges of "up to 25 wt.%, or, more specifically, 5 wt.% to 20 wt.%", is inclusive of the endpoints and all intermediate values of the ranges of "5 wt.% to 25 wt.%," etc.).

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

In the drawings, the thickness of layers, films, panels, regions, etc., are exaggerated for clarity. Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims. Like reference numerals designate like elements throughout the specification.

Hereinafter, a value of a work function or (HOMO or LUMO) energy level is expressed as an absolute value from a vacuum level. In addition, when the work function or energy level is referred to be deep, high, or large, it may have a large absolute value based on "0 eV" of the vacuum level while the work function or energy level is referred to be shallow, low, or small, it may have a small absolute value based on "0 eV" of the vacuum level. In an aspect, work function herein refers to a minimum energy required to remove an electron from e.g., a solid metal (e.g., a metal surface) to vacuum (e.g., immediately outside the solid surface).

As used herein, when a definition is not otherwise provided, "substituted" refers to replacement of hydrogen of a compound or a corresponding moiety by a substituent selected from a C1 to C30 alkyl group, a C2 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heteroaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), and a combination thereof.

As used herein, the description that does not contain cadmium (or other toxic heavy metals) means that the concentration of cadmium (or the corresponding heavy metal) is less than or equal to about 100 parts per million (ppm), less than or equal to about 50 ppm, less than or equal to about 10 ppm, or 0. In an embodiment, substantially no cadmium (or other heavy metal) is present, or, if present, cadmium is present in an amount or impurity level below the detection limit of a given detection means.

As used herein, "Group" in terms of Group VI, Group III, and the like refers to a group of the Periodic Table of Elements.

As used herein, "Group III" may refer to Group IIIA and Group IIIB, and examples of Group III metal may be Al, In, Ga, and Tl, but are not limited thereto.

"Group VI" includes Group VIA and includes sulfur, selenium, and tellurium, but is not limited thereto.

Here, quantum efficiency is a term used interchangeably with quantum yield. The quantum efficiency (or quantum yield) may be measured in solution or solid state (e, g, in a complex). In an embodiment, quantum efficiency (or quantum yield) is the ratio of emitted photons to absorbed photons of the nanostructure or population thereof. In an embodiment, quantum efficiency may be measured by any suitable method. For example, for fluorescence quantum yield or efficiency, there may be two methods: an absolute method and a relative method. In the absolute method, quantum efficiency is obtained by detecting the fluorescence of all samples through an integrating sphere. In the relative method, the quantum efficiency of the unknown sample is calculated by comparing the fluorescence intensity of a standard dye (standard sample) with the fluorescence intensity of the unknown sample. Coumarin 153, Coumarin 545, Rhodamine 101 inner salt, Anthracene and Rhodamine 6G may be used as standard dyes according to their photoluminescence (PL) wavelengths, but the present disclosure is not limited thereto.

As used herein, nanoparticle refers to a structure having at least one region or characteristic dimension having a nanoscale dimension. In an embodiment, the dimensions of the nanoparticle may be less than about 300 nanometers (nm), less than about 250 nm, less than about 150 nm, less than about 100 nm, less than about 50 nm, or less than about 30 nm. These structures may have any shape. Unless otherwise specified, the nanoparticles may have any shape, such as nanowires, nanorods, nanotubes, multi-pod type shapes having two or more pods, or nanodots (or quantum dots), and are not particularly limited. The nanoparticles may be, for example, substantially crystalline, substantially monocrystalline, polycrystalline, amorphous, or a combination thereof.

Semiconductor-based (i.e., semiconductor-containing, or semiconductor) nanocrystal particles are attracting attention as light emitting materials in various fields such as display devices, energy storage or conversion devices, or bioluminescent devices. Some luminescent nanocrystal particles may contain hazardous heavy metals such as cadmium (Cd), lead, mercury, or a combination thereof, and from an environmental point of view, it is desirable to develop nanocrystal particles of various compositions capable of exhibiting desired optical properties (e.g., capable of emitting light in a desired wavelength range) without including harmful heavy metals such as cadmium.

A gallium sulfide-based (i.e., gallium sulfide-containing) nanocrystal particle may exhibit a relatively wide direct energy bandgap (e.g., a difference between a valence band level and a conduction band level), for example, a band gap energy of about 2.5 electronvolts (eV) to about 3.4 eV. Surprisingly, the present inventors have found that the gallium sulfide-based semiconductor nanocrystal particle may have a misvalency between gallium as the Group III element and sulfur as the Group VI element and may have an intrinsic defect, resulting in a variety of mid-band levels. The mid-band level may include a Ga level ($V_{Ga}$) having a level higher than the valence band, a S level ($V_s$) having a level lower than the conduction band, or a combination thereof. Accordingly, the energy bandgap may be controlled, so that the emission wavelength can be adjusted.

However, the present inventors have found that it may be difficult to control the internal defects and the band levels based thereon in the gallium sulfide-based nanocrystal particle to a desired level. In addition, unlike other cadmium-free nanocrystal particle, it is not easy to form a shell on a gallium sulfide nanocrystal, and there is a limit to the achievable luminous efficiency due to such a surface defect. In the prior art, gallium sulfide-based nanocrystal particle has a maximum luminous efficiency of less than or equal to about 25% and/or have a very large full width at half maximum.

In an embodiment, a nanocrystal particle comprises a Group III-VI compound. The Group III-VI compound includes a Group 13 element including gallium and a Group 16 element including sulfur. The nanocrystal particle is configured to emit a first light (e.g., blue light). The first light may have a maximum emission peak in a wavelength range of greater than or equal to about 300 nm and less than or equal to about 485 nm, for example, when analyzed by photoluminescence spectroscopy analysis or electroluminescence spectroscopy analysis. The nanocrystal particle may have an absolute quantum efficiency of greater than or equal to about 26%. The maximum emission peak may have a full width at half maximum of greater than or equal to about 10 nanometers and less than or equal to about 70 nm. In the nanocrystal particle, a molar ratio of sulfur to gallium may be greater than or equal to about 1.2, greater than or equal to about 1.8 and less than or equal to about 4.5, based on a total content of the sulfur and the gallium in the nanocrystal particle.

In an aspect, the nanocrystal particle comprises:

a Group III-VI compound comprising gallium and sulfur,
wherein the nanocrystal particle is configured to emit a first light,
a maximum emission peak of the first light is in a wavelength range of greater than or equal to about 300 nanometers and less than or equal to about 485 nanometers,
an absolute quantum efficiency of the nanocrystal particle is greater than or equal to about 26%, and
a full width at half maximum of the maximum emission peak of the first light is greater than or equal to about 10 nanometers and less than or equal to about 70 nanometers, for example, when analyzed by (photo)luminescence spectroscopy.

The nanocrystal particle of an embodiment may exhibit a narrowed full width at half maximum with significantly increased luminous efficiency while including, for example, a core including gallium sulfide as a predominant component. In an embodiment, according to a producing method, the nanocrystal particle (e.g., gallium sulfide-based nanocrystal particle) with a controlled level of defects may be synthesized (e.g., in a one-pot manner). The gallium sulfide-based nanocrystal particle may have the composition and/or internal structure of the particles described herein (e.g., core-shell structure), and may exhibit a narrow full width at half maximum with improved luminous efficiency (e.g., an absolute quantum efficiency). The nanocrystal particle of an embodiment may exhibit increased chemical stability.

The toxicity of the nanocrystal particle of an embodiment may be controlled to a low level and may be substantially free of hazardous heavy metals (e.g., cadmium, lead, mercury, or a combination thereof).

In an embodiment, the nanocrystal particle or the Group III-VI compound included therein includes a Group 13 element and a Group 16 element (or a binding between them). The Group 13 element includes gallium, and may further include indium, aluminum, thallium, or a combination thereof. The Group 13 element may not include aluminum. The Group 16 element includes sulfur. The Group 16 element may further include selenium, tellurium, or a combination thereof. The Group 16 element may or may not include oxygen.

The Group III-VI compound may include a gallium sulfide, such as alpha-$Ga_2S_3$, an indium gallium sulfide, or a combination thereof. The Group III-VI compound may further include a dopant, for example, an additional metallic dopant, an additional anionic dopant, or a combination thereof. The additional metallic dopant may include a Group 11 metal, such as silver, gold, copper, or a combination thereof. The nanocrystal particle may not include the dopant.

In an embodiment, the nanocrystal particle include the dopant, and an amount of the dopant may be greater than or equal to about 0.01 moles, greater than or equal to about 0.1 moles, greater than or equal to about 0.2 moles and less than or equal to about 10 moles, less than or equal to about 5 moles, less than or equal to about 2 moles, less than or equal to about 1 mole, or less than or equal to about 0.4 moles, per a mole of the gallium.

In the nanocrystal particle, the gallium may be distributed with a concentration gradient. In the nanocrystal particle of an embodiment, the gallium may be predominantly present within the particle. In the nanocrystal particle, the gallium may exhibit a concentration gradient that decreases from the center to the surface of the particle.

In an embodiment, the nanocrystal particle may have a core-shell structure having a core and a shell disposed on the core. The core may include the gallium sulfide. A gallium content of the core may be greater than a gallium content of the shell. The shell may or may not include gallium.

A size of the core may be greater than or equal to about 0.5 nm, greater than or equal to about 1 nm, greater than or equal to about 1.5 nm, greater than or equal to about 2 nm, or greater than or equal to about 2.5 nm. The size of the core may be less than or equal to about 5 nm, less than or equal to about 4 nm, less than or equal to about 3 nm, or less than or equal to about 2.2 nm. The core may have, for example, a sulfur-rich surface.

The shell may further include zinc, aluminum, or a combination thereof. The shell may include a Group II-VI compound (e.g., zinc chalcogenide). The Group II-VI compound may include zinc selenide, zinc sulfide, zinc selenide sulfide, zinc telluride, zinc telluride sulfide, zinc telluride selenide, or a combination thereof. The shell may include a metal oxide, for example, aluminum oxide. In an embodiment, the shell may include zinc sulfide, aluminum oxide, or a combination thereof.

The shell may have a multi-layered shell structure. In the multi-layered shell, adjacent layers may include semiconductor materials having different compositions. The multi-layered shell may include a first shell layer disposed on the core (or directly on the core) and including a first semiconductor nanocrystal and a second shell layer disposed on the first shell layer and including a second semiconductor nanocrystal.

The first shell layer or the first semiconductor nanocrystal may include zinc chalcogenide (e.g., zinc sulfide, zinc selenide, zinc selenide sulfide, or a combination thereof). The second shell layer may include aluminum oxide. The second shell layer may include a surface of the nanocrystal particle. The second shell layer may be an outermost layer of the nanoparticle.

In an embodiment, the core-shell structure (e.g., core/shell) or the core-multi-layered shell structure (e.g., core/first shell/second shell) includes a $Ga_2S_3$ core/ZnS, a $Ga_2S_3$ core/ZnSe/ZnS, a $Ga_2S_3$ core/ZnSe/ZnS $Al_2O_3$, a $Ga_2S_3$ core/ZnS/$Al_2O_3$, or a combination thereof.

A shell thickness (e.g., in the case of a multi-layered shell, a thickness of the first shell layer, a thickness of the second shell layer, or a sum thereof) may be about 1 monolayer (ML) or greater, about 2 ML or greater, about 3ML or greater, about 4 ML or greater, about 5 ML or greater, about 6 ML or greater, or about 7 ML or greater. The shell thickness (e.g., in the case of a multi-layered shell, the thickness of the first shell layer, the thickness of the second shell layer, or the sum thereof) may be about 10 ML or less, about 8 ML or less, about 6.5 ML or less, about 5.5 ML or less, about 4.5 ML or less, or about 3.5 ML or less. The shell thickness (e.g., in the case of a multi-layered shell, the thickness of the first shell layer, the thickness of the second shell layer, or the sum thereof) may be greater than or equal to about 0.3 nm, greater than or equal to about 0.5 nm, greater than or equal to about 0.6 nm, greater than or equal to about 0.9 nm, greater than or equal to about 1 nm, greater than or equal to about 1.2 nm, greater than or equal to about 1.5 nm, greater than or equal to about 1.8 nm, greater than or equal to about 2 nm, greater than or equal to about 2.5 nm, or greater than or equal to about 2.8 nm. The shell thickness (e.g., in the case of a multi-layered shell, the thickness of the first shell layer, the thickness of the second shell layer, or the sum thereof) may be less than or equal to about 10 nm, less than or equal to about 7 nm, less than or equal to about 5 nm, less than or equal to about 4.5 nm, less than or equal to about 4 nm, less than or equal to about 3.5 nm, less than or equal to about 3 nm, less than or equal to about 2.6 nm, less than or equal to about 2.3 nm, less than or equal to about 2.1 nm, less than or equal to about 1.7 nm, less than or equal to about 1.4 nm, or less than or equal to about 0.9 nm.

In an embodiment, the nanocrystal particle may have a (average) size of greater than or equal to about 2 nm, greater than or equal to about 3 nm, greater than or equal to about 4 nm, or greater than or equal to about 5 nm and less than or equal to about 50 nm. The nanocrystal particle may have a size (a diameter or an equivalent diameter) or an average particle size (e.g., an average of diameters or average equivalent diameters of particles confirmed by electron microscopy) of greater than or equal to about 3 nm, greater than or equal to about 4 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, greater than or equal to about 10.5 nm, greater than or equal to about 11 nm, greater than or equal to about 11.5 nm, or greater than or equal to about 12 nm. The (average) size of the nanoparticle(s) may be less than or equal to about 50 nm, for example, less than or equal to about 40 nm, less than or equal to about 35 nm, less than or equal to about 29 nm, less than or equal to about 28 nm, less than or equal to about 27 nm, less than or equal to about 26 nm, less than or equal to about 25 nm, less than or equal to about 24 nm, less than or equal to about 23 nm, less than or equal to about 22 nm, less than or equal to about 21 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, less than or equal to about 12 nm, less than or equal to about 10 nm, less than or equal to about 9 nm, less than or equal to about 8 nm, less than or equal to about 7 nm, less than or equal to about 6 nm, or less than or equal to about 5 nm. As used herein, the average may be mean. As used herein, the average may be median.

The size of the particle may be determined easily and reproducibly using a known or commercially available image analysis tool (e.g., Image J) from photographs of particles obtained by electron microscopy (e.g., scanning electron microscopy or transmission electron microscopy) analysis. The tool for the image analysis is not particularly limited.

The nanocrystal particle may have a molar ratio of sulfur to gallium (moles of the sulfur/ moles of the gallium) of greater than or equal to about 1.2, greater than or equal to about 1.4, greater than or equal to about 1.5, greater than or equal to about 1.6, greater than or equal to about 1.8, greater than or equal to about 1.85, greater than or equal to about 1.9, greater than or equal to about 2, greater than or equal to about 2.1, greater than or equal to about 2.3, or greater than or equal to about 2.4. The molar ratio of the sulfur to the gallium may be less than or equal to about 5, less than or equal to about 4.5, less than or equal to about 4.2, less than or equal to about 4, less than or equal to about 3.8, less than or equal to about 3.5, less than or equal to about 3.6, less than or equal to about 3.3, less than or equal to about 3, less than or equal to about 2.8, less than or equal to about 2.6, or less than or equal to about 2.45 in the nanocrystal particle.

The nanocrystal particle may further include zinc, and a molar ratio of zinc to gallium (i.e., moles of the zinc/moles of the gallium) may be greater than or equal to about 0.05, greater than or equal to about 0.1, greater than or equal to about 0.15, or greater than or equal to about 0.2, based on a total content of the zinc and the gallium in the nanocrystal particle. The molar ratio of zinc to gallium may be less than or equal to about 1.5, less than or equal to about 1, less than or equal to about 0.8, less than or equal to about 0.5, less than or equal to about 0.3, less than or equal to about 0.18, or less than or equal to about 0.12 in the nanocrystal particle.

The nanocrystal particle may further include aluminum, and in the nanocrystal particle, a molar ratio of aluminum to gallium (i.e., moles of the aluminum/moles of the gallium) may be greater than or equal to about 0.1, greater than or equal to about 0.5, greater than or equal to about 1, greater than or equal to about 3, greater than or equal to about 5, or greater than or equal to about 7. In the nanocrystal particle, the molar ratio of the aluminum to the gallium may be less than or equal to about 15, less than or equal to about 10, less than or equal to about 8, or less than or equal to about 3, in the nanocrystal particle. The amount of an element or a molar ratio between the elements described herein may be confirmed by an appropriate analytical tool (e.g., X-ray photoelectron spectroscopy, inductively coupled plasma atomic emission spectroscopy, transmission electron microscopy-energy-dispersive X-ray (TEM-EDX) spectroscopy, etc.).

The nanocrystal particle of an embodiment may have gallium peaks suggesting a gallium-sulfur bond (e.g., $Ga2p_{3/2}$) in the range of greater than or equal to about 1113 eV, greater than or equal to about 1116 eV, or greater than or equal to about 1117 eV and less than or equal to about 1122 eV, or less than or equal to about 1119 eV in XPS analysis.

The nanocrystal particle may comprise the gallium sulfide having a monoclinic crystal structure (e.g., Monoclinic $\alpha$-$Ga_2S_3$ (space group Cc (No. 9) JCPDS no. 01-076-0752), when analyzed by X-ray diffraction using CuK$\alpha$ radiation.

Accordingly, the X-ray diffraction spectrum of the nanocrystal particle of an embodiment may exhibit a first peak at a diffraction angle, 2theta, in the range of about 15 degrees to about 23 degrees. The first peak may exist at 2 theta in the range of about 18 degrees to about 22 degrees, about 19 degrees to about 21.5 degrees, about 19.5 degrees to about 21 degrees, about 20 degrees to about 20.5 degrees, or a combination thereof. The full width at half maximum of the first peak may be greater than or equal to about 0.5 degree, greater than or equal to about 1 degree, greater than or equal to about 1.5 degrees, greater than or equal to about 2 degrees, or greater than or equal to about 5 degrees. The full width at half maximum of the first peak may be less than or equal to about 15 degrees, less than or equal to about 13 degrees, less than or equal to about 10 degrees, less than or equal to about 8 degrees, less than or equal to about 6 degrees, less than or equal to about 4 degrees, or less than or equal to about 3.5 degrees.

The nanocrystal particle may exhibit a second peak at the diffraction angle, 2 theta, in the range of about 25 degrees to about 32 degrees, about 27 degrees to about 31.5 degrees, about 28 degrees to about 31 degrees, about 29 degrees to about 30.5 degrees, or a combination thereof, as confirmed by X-ray diffraction analysis.

The nanocrystal particle may exhibit a third peak at the diffraction angle, 2 theta, in the range of about 33 degrees to about 39 degrees, about 33.5 degrees to about 38 degrees, about 34 degrees to about 37 degrees, or a combination thereof, as confirmed by X-ray diffraction analysis. The full width at half maximum of the third peak may be greater than or equal to about 2 degrees, greater than or equal to about 5 degrees, or greater than or equal to about 7 degrees, greater than or equal to about 10 degrees, and less than or equal to about 20 degrees, or less than or equal to about 18 degrees, less than or equal to about 15 degrees, less than or equal to about 13 degrees, less than or equal to about 9 degrees.

The nanocrystal particle of an embodiment, for example, may exhibit improved luminous efficiency and reduced full width at half maximum, while emitting light of a desired range of emission wavelength (i.e., the first light) by photoexcitation or voltage application. The nanocrystal particle may be configured to emit light (e.g., blue light, green light, or red light) having a wavelength in the visible light region. The maximum emission peak wavelength of the first light emitted by the nanocrystal particle of an embodiment may be greater than or equal to about 375 nm, greater than or equal to about 380 nm, greater than or equal to about 385 nm, greater than or equal to about 390 nm, greater than or equal to about 395 nm, greater than or equal to about 400 nm, or greater than or equal to about 405 nm. The maximum emission peak wavelength of the first light may be less than or equal to about 475 nm, less than or equal to about 470 nm, less than or equal to about 465 nm, less than or equal to about 460 nm, less than or equal to about 455 nm, less than or equal to about 450 nm, or less than or equal to about 445 nm.

The nanocrystal particle may have a quantum efficiency (or absolute quantum efficiency) of greater than or equal to about 26%, greater than or equal to about 27%, greater than or equal to about 28%, greater than or equal to about 29%, greater than or equal to about 30%, greater than or equal to about 32%, greater than or equal to about 33%, greater than or equal to about 34%, greater than or equal to about 35%, greater than or equal to about 36%, greater than or equal to about 37%, greater than or equal to about 38%, greater than or equal to about 39%, or greater than or equal to about 40%. The absolute quantum efficiency may be between about 41% and about 100%, between about 42% and about 90%, between about 43% and about 80%, between about 44% and about 75%, or between about 45% and about 60%.

The full width at half maximum of the maximum emission peak of the first light may be less than or equal to about 70 nm, less than or equal to about 60 nm, less than or equal to about 50 nm, less than or equal to about 48 nm, less than or equal to about 45 nm, less than or equal to about 44 nm, less than or equal to about 42 nm, less than or equal to about 40 nm, less than or equal to about 38 nm, less than or equal to about 36 nm, less than or equal to about 34 nm, less than or equal to about 32 nm, or less than or equal to about 30 nm, for example, when analyzed by a (photo) luminescence spectroscopy. The full width at half maximum of the maximum emission peak of the first light may be greater than or equal to about 10 nm, greater than or equal to about 20 nm, or greater than or equal to about 25 nm.

In the UV-Vis absorption spectrum of the nanocrystal particles, a valley depth (VD) defined by the following equation may be greater than or equal to about 0.1, greater than or equal to about 0.2, greater than or equal to about 0.3, greater than or equal to about 0.4, or greater than or equal to about 0.5:

$$1 - (Abs_{valley} / Abs_{first}) = VD$$

wherein $Abs_{first}$ is an absorption at the first absorption peak and $Abs_{valley}$ is an absorption at the lowest point of the valley adjacent to the first absorption peak.

The nanocrystal particle may have a bandgap energy (e.g., calculated from UV absorption spectrum) of greater than or equal to about 2.6 eV, greater than or equal to about 2.7 eV, greater than or equal to about 2.8 eV, greater than or equal to about 2.9 eV, greater than or equal to about 3 eV, greater than or equal to about 3.1 eV, greater than or equal to about 3.2 eV, greater than or equal to about 3.29 eV, greater than or equal to about 3.3 eV, or greater than or equal to about 3.35 eV and less than or equal to about 3.5 eV, or less than or equal to about 3.4 eV.

The nanocrystal particle may have an average lifetime of greater than or equal to about 0.5 nanosecond (ns), greater than or equal to about 0.8 ns, greater than or equal to about 0.9 ns, greater than or equal to about 1 ns, greater than or equal to about 5 ns, greater than or equal to about 10 ns, or greater than or equal to about 15 ns in a time-resolved photoluminescence spectroscopy. The nanocrystal particle may have an average lifetime (tau average) of less than or equal to about 100 ns, less than or equal to about 80 ns, less than or equal to about 70 ns, less than or equal to about 60 ns, less than or equal to about 50 ns, less than or equal to about 30 ns, less than or equal to about 10 ns, less than or equal to about 6 ns, less than or equal to about 5 ns, less than or equal to about 4 ns, less than or equal to about 3 ns, or less than or equal to about 2 ns in a time-resolved photoluminescence spectroscopy.

The nanocrystal particle may exhibit an improved stability.

In an embodiment, when an experiment of keeping the nanocrystal particle in the atmosphere for 7.5 days is conducted, the nanocrystal particle may have a quantum efficiency maintenance of greater than or equal to about 80%, greater than or equal to about 85%, greater than or equal to about 90%, or greater than or equal to about 92%, and less than or equal to about 100%, less than or equal to about 99.5%, or less than or equal to about 99% of an initial quantum efficiency of the nanocrystal particle The initial quantum efficiency herein may refer to a quantum efficiency measured right before the experiment is started (i.e., time is zero).

In an embodiment, when an experiment of keeping the nanocrystal particle in the atmosphere for 15 days is conducted, the nanocrystal particle may exhibit an improved quantum efficiency maintenance of greater than or equal to about 80%, greater than or equal to about 85%, greater than or equal to about 90%, or greater than or equal to about 92%, and less than or equal to about 100%, less than or equal to about 99.5%, or less than or equal to about 99% of the initial quantum efficiency.

The nanocrystal particle may have an improved quantum efficiency of greater than or equal to about 50%, greater than or equal to about 65%, greater than or equal to about 70%, greater than or equal to about 75%, greater than or equal to about 80%, greater than or equal to about 85%, greater than or equal to about 90%, or greater than or equal to about 92%, and less than or equal to about 100%, less than or equal to about 99.5%, or less than or equal to about 99%, relative to the initial quantum efficiency after being left in the atmosphere for 30 days.

In an embodiment, the method for producing the nanocrystal particle(s) includes reacting a gallium precursor, a sulfur precursor, and optionally a dopant precursor in an organic solvent in the presence of an additive (or organic ligand) at a first reaction temperature forming gallium sulfide. In the method, a content of the sulfur precursor per mole of the gallium precursor is greater than or equal to about 4 moles, greater than or equal to about 4.5 moles, or greater than or equal to about 5 moles.

In an aspect, the method for producing the nanocrystal particle comprises:

contacting a gallium precursor, a sulfur precursor, and an additive in an organic solvent to provide a reaction system comprising gallium sulfide,
wherein a content of the sulfur precursor per 1 mole of the gallium precursor is greater than or equal to about 4 moles and less than or equal to about 50 moles,

wherein the nanocrystal particle comprises

a Group III-VI compound comprising gallium and sulfur,

wherein the nanocrystal particle is configured to emit a first light,

a maximum emission peak of the first light is in a wavelength range of greater than or equal to about 300 nanometers and less than or equal to about 485 nanometers,

an absolute quantum efficiency of the nanocrystal particle is greater than or equal to about 26%, and

a full width at half maximum of the maximum emission peak of the first light is greater than or equal to about 10 nanometers and less than or equal to about 70 nanometers,

when analyzed by a (photo)luminescence spectroscopy.

The method may include mixing the gallium precursor, the sulfur precursor, the additive (or the organic ligand), and optionally a dopant precursor in the organic solvent, and heating-up the resulting mixture to a first reaction temperature.

The method may include hot injection of adding a precursor (e.g., a gallium precursor or a sulfur precursor, and a dopant precursor) to a heated reaction medium. The heated reaction medium may include a heated organic solvent, optionally either a gallium precursor or a sulfur precursor, and optionally an additive or an organic ligand.

In the method of an embodiment, the formed gallium sulfide nanocrystals may be isolated and, optionally, a subsequent reaction may proceed. In the method of an embodiment, a subsequent reaction (e.g., a shell-forming reaction) may proceed without separation of the formed gallium sulfide nanocrystals. The method of an embodiment may be a one pot method.

The method may further include adding a zinc precursor, an aluminum precursor, or a combination thereof, optionally together with an organic ligand, to the reaction system including the gallium sulfide. After the addition, a subsequent reaction (e.g., a shell formation reaction) may be performed to form a shell layer on the gallium sulfide. In an embodiment, the zinc precursor is added to the reaction system to form a first shell layer including zinc sulfide, and then the aluminum precursor is added to the reaction system to form a second shell layer including an aluminum compound (e.g., aluminum oxide).

The subsequent reaction or the shell-forming reaction may proceed at a second reaction temperature. The second reaction temperature may be greater than the first reaction temperature. The second reaction temperature may be less than the first reaction temperature. A difference between the first reaction temperature and the second reaction temperature may be greater than or equal to about 10 °C, greater than or equal to about 20 °C, greater than or equal to about 30 °C, greater than or equal to about 40 °C, or greater than or equal to about 50 °C. The difference between the first reaction temperature and the second reaction temperature may be less than or equal to about 100 °C, or less than or equal to about 90 °C.

The reaction time for forming the gallium sulfide and/or the reaction time for forming the shell may be appropriately determined in consideration of the composition and size of the final nanoparticles, and are not particularly limited. The reaction time may be greater than or equal to about 1 minute, greater than or equal to about 5 minutes, greater than or equal to about 10 minutes, greater than or equal to about 15 minutes, greater than or equal to about 20 minutes, greater than or equal to about 30 minutes, or greater than or equal to about 40 minutes. The reaction time may be less than or equal to about 10 hours, less than or equal to about 5 hours, less than or equal to about 3 hours, less than or equal to about 2 hours, or less than or equal to about 1 hour. In the method of an embodiment, the emission wavelength of the nanocrystal particle may be controlled by adjusting the reaction time.

The first reaction temperature may be greater than or equal to about 200 °C, greater than or equal to about 250 °C, greater than or equal to about 260 °C, greater than or equal to about 270 °C, greater than or equal to about 280 °C, greater than or equal to about 290 °C, or greater than or equal to about 300 °C. The first reaction temperature may be less than or equal to about 400 °C, less than or equal to about 350 °C, or less than or equal to about 290 °C.

The gallium precursor may be a gallium powder, an alkylated gallium compound, gallium alkoxide, gallium carboxylate, gallium nitrate, gallium perchlorate, gallium sulfate, gallium acetylacetonate, gallium halide, gallium cyanide, gallium hydroxide, gallium oxide, gallium peroxide, gallium carbonate, gallium chloride, gallium bromide, gallium iodide, or a combination thereof. The gallium precursor may include gallium chloride, gallium iodide, gallium bromide, gallium acetate, gallium acetylacetonate, gallium oleate, gallium palmitate, gallium stearate, gallium myristate, gallium hydroxide, or a combination thereof. In an embodiment, the gallium precursor may include gallium carboxylate, gallium acetylacetonate, or a combination thereof.

The dopant precursor may be a metal powder, an alkylated metal compound, a metal alkoxide, a metal carboxylate, a metal nitrate, a metal perchlorate, a metal sulfate, a metal acetylacetonate, a metal halide, a metal cyanide, a metal hydroxide, a metal oxide, a metal peroxide, a metal carbonate, a metal chloride, a metal bromide, a metal iodide, or a combination thereof. The specific type of metal included in the dopant precursor is as described for the dopant.

The sulfur precursor may be a sulfur powder, an organic solvent dispersion or reaction product of sulfur, (e.g., sulfur-oleylamine (S-oleylamine), sulfur-dodecylamine (S-dodecylamine), sulfur-octadecene (S-ODE), sulfurtrioctylphosphine (S-TOP), sulfur-tributylphosphine- (S-TBP), sulfurtriphenylphosphine (S-TPP), sulfur-trioctylamine (S-TOA), bis(trimethylsilylalkyl) sulfide, bis(trimethylsilyl)sulfide, mercaptopropyl silane, ammonium sulfide, sodium sulfide, a C1-30 thiol compound (e.g., $\alpha$-toluene thiol, octane thiol, dodecane thiol, octadecene thiol, etc.), an isothiocyanate compound (e.g., cyclohexyl isothiocyanate), alkylene trithiocarbonate (e.g., ethylene trithiocarbonate), allyl mercaptan, a thiourea compound (e.g., thiourea, dialkylthiourea, or phenylthiourea), or a combination thereof. In an embodiment, the sulfur precursor may include a sulfur powder, an organic solvent dispersion or a reaction product of sulfur, or a combination thereof.

The additive may include a phosphine compound having a C1 to C30 (C3 to C24) hydrocarbon group (e.g., an alkyl, alkenyl, or alkynyl group). The additive may include $R_3P$, $R_3PO$, or a combination thereof (wherein R is each independently hydrogen, or a substituted or unsubstituted C1 to C30 (C3 to C24) hydrocarbon group, and at least one R is a substituted or unsubstituted C1 to C30 (C3 to C24) hydrocarbon group). The additive may include a monoalkylphosphine; dialkylphosphine; trialkylphosphine (e.g., trimethyl phosphine, ethyldimethyl phosphine, propyldimethyl phosphine, butyldimethyl phosphine, pentyldiethyl phosphine, tributylphosphine, trioctylphosphine, etc.); an aryl phosphine compound such as diphenyl phosphine and triphenyl phosphine; a phosphine oxide compound such as methyl phosphine oxide, ethyl phosphine oxide, propyl phosphine oxide, butyl phosphine oxide, and trioctylphosphine oxide; or an oxide compound thereof.

The organic ligand may include RCOOH, $RNH_2$, $R_2NH$, $R_3N$, RSH, $RH_2PO$, $R_2HPO$, $R_3PO$, $RH_2P$, $R_2HP$, $R_3P$, ROH, RCOOR', $RPO(OH)_2$, $R_2POOH$, or a combination thereof, wherein R and R' may each independently include a substituted or unsubstituted $C_{1-40}$ aliphatic hydrocarbon group, or a substituted or unsubstituted $C_{6-40}$ aromatic hydrocarbon group, or a combination thereof. Specific examples of the organic ligand compound may include methane thiol, ethane thiol, propane thiol, butane thiol, pentane thiol, hexane thiol, octane thiol, dodecane thiol, hexadecane thiol, octadecane thiol, benzyl thiol; methane amine, ethane amine, propane amine, butane amine, pentane amine, hexane amine, octane amine, dodecane amine, hexadecyl amine, oleyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid, palmitic acid, stearic acid; phosphonic acid, and the like, but are not limited thereto. The organic ligand compound may be used alone or as a mixture of two or more.

The organic solvent may include a C1 to C50 amine (a C6 to C30 primary amine such as hexadecylamine, a C6 to C30 secondary amine such as dioctylamine, and a C6 to C40 tertiary amine such as trioctylamine), a nitrogen-containing heterocyclic compound such as pyridine, a C6 to C40 olefin such as octadecene, a C6 to C40 aliphatic hydrocarbon such as hexadecane, octadecane, and squalane, aromatic hydrocarbons substituted with a C6 to C30 alkyl group such as phenyldodecane, phenyltetradecane, phenylhexadecane, etc., primary, secondary, or tertiary phosphines substituted with at least one (e.g., 1, 2, or 3) C6 to C22 alkyl groups (e.g., trioctylphosphine), primary, secondary, or tertiary phosphine oxide (e.g. trioctylphosphine oxide) substituted with a (e.g., 1, 2, or 3) C6 to C22 alkyl group, phenyl ether, a C12 to C22 aromatic ether such as benzyl ether, or a combination thereof. The organic solvent may not include oxygen or an oxygen-containing moiety. The organic solvent may include a C3 to C80 (C10 to C40) tertiary amine compound such as trioctylamine, a C2 to C80 (C10 to C40) alkene compound such as octadecene, or a combination thereof.

The amount of the sulfur precursor per 1 mole of the gallium precursor may be greater than or equal to about 6 moles, or greater than or equal to about 7 moles, greater than or equal to about 8 moles, greater than or equal to about 9 moles, or greater than or equal to about 10 moles. The amount of the sulfur precursor per 1 mole of the gallium precursor may be less than or equal to about 50 moles, or less than or equal to about 20 moles, or less than or equal to about 15 moles, less than or equal to about 13 moles, or less than or equal to about 11 moles.

If present, the amount of the zinc precursor, the aluminum precursor, or the dopant precursor may be adjusted in consideration of the desired content of the corresponding metal or dopant in the nanocrystal particle.

After the gallium sulfide formation reaction or the shell formation reaction is completed, if a nonsolvent is added to the reaction product (e.g., the ligand compound is coordinated), the semiconductor nanocrystal particles (e.g., nanocrystals) may be separated. The nonsolvent may be a polar solvent that is miscible with the solvent used for the core formation and/or shell formation reactions but cannot disperse the produced nanocrystals. The nonsolvent may be determined depending on the solvent used for the reaction, and may be for example, acetone, ethanol, butanol, isopropanol, ethanediol, water, tetrahydrofuran (THF), dimethyl sulfoxide (DMSO), diethyl ether, formaldehyde, acetaldehyde, a solvent having a solubility parameter similar to the above nonsolvent, or a combination thereof. Separation may use centrifugation, precipitation, chromatography, or distillation. The separated nanocrystals may be washed by being added to a washing solvent as needed. The washing solvent is not particularly limited, and a solvent having a solubility parameter similar to that of the ligand may be used, and examples thereof may include hexane, heptane, octane, chloroform, toluene, and benzene.

The nanocrystal particle of an embodiment may be non-dispersible or insoluble with respect to water, the aforementioned nonsolvent, or a combination thereof.

The nanocrystal particle of an embodiment may be dispersed in the aforementioned organic solvent. In an embodiment, the aforementioned nanocrystal particle may be dispersed in a substituted or unsubstituted C6 to C40 aliphatic hydrocarbon, a substituted or unsubstituted C6 to C40 aromatic hydrocarbon, or a combination thereof.

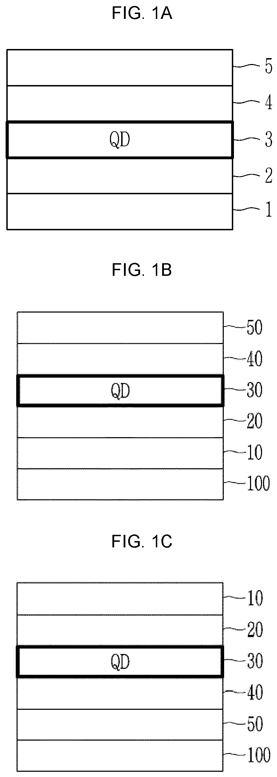

An embodiment provides an electroluminescent device including the aforementioned nanocrystal particles. The electroluminescent device includes a first electrode 1 and a second electrode 5 spaced apart (e.g., facing each other); and a light emitting layer 3 that is disposed between the first electrode and the second electrode and does not include cadmium (refer to FIG. 1A). The first electrode may include an anode, and the second electrode may include a cathode. Alternatively, the first electrode may include a cathode and the second electrode may include an anode. The electroluminescent device may further include a hole auxiliary layer 2 between the light emitting layer and the first electrode. The electroluminescent device may further include an electron auxiliary layer 4 between the light emitting layer and the second electrode. The light emitting layer may include nanocrystal particles. Details of the nanocrystal particle are the same as described above.

In the electroluminescent device, the first electrode 10 or the second electrode 50 may be disposed on a (transparent) substrate 100. The transparent substrate may be a light extraction surface. (Refer to FIGS. 1B and 1C)

Referring to FIGS. 1B and 1C, the light emitting layer 30 may be disposed between the first electrode (e.g., anode) 10 and the second electrode (e.g., cathode) 50. The second electrode or cathode 50 may include an electron injection conductor. The first electrode or anode 10 may include a hole injection conductor. The work function of the electron/hole injection conductor included in the second electrode and the first electrode may be appropriately adjusted and are not particularly limited. For example, the second electrode may have a small work function, and the first electrode may have a relatively large work function, or vice versa.

The electron/hole injection conductors may include a metal-based material (e.g., a metal, a metal compound, an alloy, or a combination thereof) (aluminum, magnesium, tungsten, nickel, cobalt, platinum, palladium, calcium, LiF, etc.), a metal oxide such as gallium indium oxide or indium tin oxide (ITO), or a conductive polymer (e.g., having a relatively high work function) such as polyethylene dioxythiophene, but are not limited thereto.

At least one of the first electrode and the second electrode may be a light-transmitting electrode or a transparent electrode. In an embodiment, both the first electrode and the second electrode may be a light-transmitting electrode. The electrode(s) may be patterned. The first electrode and/or the second electrode may be disposed on a (e.g., insulating) substrate 100. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and for example, less than or equal to about 99%, or less than or equal to about 95%). The substrate may further include a region for a blue pixel, a region for a red pixel, a region for a green pixel, or a combination thereof. A thin film transistor may be disposed in each region of the substrate, and one of a source electrode and a drain electrode of the thin film transistor may be electrically connected to the first electrode or the second electrode.

The light-transmitting electrode may be disposed on a (e.g., insulating) transparent substrate. The substrate may be rigid or flexible. The substrate may be plastic, glass, or a metal.

The light-transmitting electrode may be made of, for example, a transparent conductor such as indium tin oxide (ITO) or indium zinc oxide (IZO), gallium indium tin oxide, zinc indium tin oxide, titanium nitride, polyaniline, LiF/Mg:Ag, or the like, or a metal thin film of a single layer or a plurality of layers, but is not limited thereto. When one of the first electrode and the second electrode is an opaque electrode, it may be made of an opaque conductor such as aluminum (Al), a lithium-aluminum (Li:Al) alloy, a magnesium-silver alloy (Mg;Ag), and lithium fluoride-aluminum (LiF:Al).

A thickness of the electrode (the first electrode and/or the second electrode) is not particularly limited and may be appropriately selected in consideration of device efficiency. For example, the thickness of the electrode may be greater than or equal to about 5 nm, for example, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 $\mu$m, for example, less than or equal to about 90 $\mu$m, less than or equal to about 80 $\mu$m, less than or equal to about 70 $\mu$m, less than or equal to about 60 $\mu$m, less than or equal to about 50 $\mu$m, less than or equal to about 40 $\mu$m, less than or equal to about 30 $\mu$m, less than or equal to about 20 $\mu$m, less than or equal to about 10 $\mu$m, less than or equal to about 1 $\mu$m, less than or equal to about 900 nm, less than or equal to about 500 nm, or less than or equal to about 100 nm.

A light emitting layer 3 or 30 is disposed between the first electrode 1 and the second electrode 5 (e.g., the anode 10 and the cathode 50). The light emitting layer includes nanocrystal particle(s) (e.g., blue light emitting nanoparticles, red light emitting nanoparticles, or green light emitting nanoparticles). The light emitting layer may include one or more (e.g., 2 or more or 3 or more and 10 or less) monolayers of a plurality of nanoparticles.

The light emitting layer may be patterned. In an embodiment, the patterned light emitting layer may include a blue light emitting layer (e.g., disposed within a blue pixel in a display device to be described later), a red light emitting layer (e.g., disposed within a red pixel in a display device to be described later), and a green light emitting layer (e.g., disposed within a green pixel in a display device to be described later), or a combination thereof. Each of the light emitting layers may be (e.g., optically) separated from an adjacent light emitting layer by a partition wall. In an embodiment, partition walls such as black matrices may be disposed between the red light emitting layer(s), the green light emitting layer(s), and the blue light emitting layer(s). The red light emitting layer, the green light emitting layer, and the blue light emitting layer may be optically isolated from each other.

In the light emitting device, a thickness of the light emitting layer may be appropriately selected. In an embodiment, the light emitting layer may include a monolayer(s) of nanoparticles. In another embodiment, the light emitting layer may include one or more monolayers of nanoparticles, for example two or more, three or more, or four or more and 20 or less, 10 or less, 9 or less, 8 or less, 7 or less, or 6 or less. The light emitting layer may have a thickness of greater than or equal to about 5 nm, for example, greater than or equal to about 10 nm, greater than or equal to about 20 nm, or greater than or equal to about 30 nm and less than or equal to about 200 nm, for example, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light emitting layer may have a thickness of, for example, about 10 nm to about 150 nm, for example about 20 nm to about 100 nm, for example about 30 nm to about 50 nm.

The forming of the light emitting layer may performed by obtaining a composition including nanoparticles (configured to emit desired light) and applying it on a substrate or charge auxiliary layer in an appropriate manner (e.g., by spin coating, inkjet printing, etc.) or by depositing.

The electroluminescent device may include a charge (hole or electron) auxiliary layer between the first electrode and the second electrode. For example, in the electroluminescent display device, the hole auxiliary layer 20 or the electron auxiliary layer 40 may be disposed between the first electrode 10 and the light emitting layer 30 and/or between the second electrode 50 and the light emitting layer 30. (Refer to FIGS. 1B and 1C)

The light emitting device according to an embodiment may further include a hole auxiliary layer. The hole auxiliary layer 20 may be disposed between the first electrode 10 and the light emitting layer 30. The hole auxiliary layer 20 may include a hole injection layer, a hole transport layer, and/or an electron blocking layer. The hole auxiliary layer 20 may be a single component layer or a multilayer structure in which adjacent layers include different components.

The hole auxiliary layer 20 may have a HOMO energy level that can be matched with the HOMO energy level of the light emitting layer 30 to enhance mobility of holes transferred from the hole auxiliary layer 20 to the light emitting layer 30. In an embodiment, the hole auxiliary layer 20 may include a hole injection layer close to the first electrode 10 and a hole transport layer close to the light emitting layer 30.

A material included in the hole auxiliary layer 20 (e.g., a hole transport layer, a hole injection layer, or an electron blocking layer) is not particularly limited. In the hole auxiliary layer(s), the thickness of each layer may be appropriately selected. For example, the thickness of each layer may be greater than or equal to about 5 nm, greater than or equal to about 10 nm, greater than or equal to about 15 nm, or greater than or equal to about 20 nm and less than or equal to about 100 nm, less than or equal to about 90 nm, less than or equal to about 80 nm, less than or equal to about 70 nm, less than or equal to about 60 nm, less than or equal to about 50 nm, for example, less than or equal to about 40 nm, less than or equal to about 35 nm, or less than or equal to about 30 nm, but is not limited thereto.

The electron auxiliary layer 40 is disposed between the light emitting layer 30 and the second electrode 50. The electron auxiliary layer 40 may include, for example, an electron injection layer, an electron transport layer, and/or a hole blocking layer. The electron auxiliary layer may include, for example, an electron injection layer (EIL) that facilitates injection of electrons, an electron transport layer (ETL) that facilitates transport of electrons, a hole blocking layer (HBL) that blocks the movement of holes, or combinations thereof.

In an embodiment, an electron injection layer may be disposed between the electron transport layer and the second electrode. For example, the hole blocking layer may be disposed between the light emitting layer and the electron transport (injection) layer, but is not limited thereto. The thickness of each layer may be appropriately selected. For example, the thickness of each layer may be greater than or equal to about 1 nm and less than or equal to about 500 nm, but is not limited thereto. The electron injection layer may be an organic layer formed by vapor deposition. The electron transport layer may include inorganic oxide nanoparticles or may be an organic layer formed by vapor deposition.

The electron auxiliary layer 40 may include an electron transport layer. The electron transport layer may include a plurality of nanoparticles. The plurality of nanoparticles may include a metal oxide including zinc. The metal oxide may include zinc oxide, zinc magnesium oxide, or a combination thereof. The metal oxide may include $Zn_{1-x}M_xO$, wherein M is Mg, Ca, Zr, W, Li, Ti, Y, Al, or a combination thereof and $0 \leq x \leq 0.5$. In an embodiment, M may be magnesium (Mg). In an embodiment, x may be greater than or equal to about 0.01 and less than or equal to about 0.3, for example, less than or equal to about 0.25, less than or equal to about 0.2, or less than or equal to about 0.15. The average size of the nanoparticles may be greater than or equal to about 1 nm, for example, greater than or equal to about 1.5 nm, greater than or equal to about 2 nm, greater than or equal to about 2.5 nm, or greater than or equal to about 3 nm and less than or equal to about 10 nm, less than or equal to about 9 nm, less than or equal to about 8 nm, less than or equal to about 7 nm, less than or equal to about 6 nm, or less than or equal to about 5 nm.

In an embodiment, each thickness of the electron auxiliary layer 40 (e.g., electron injection layer, electron transport layer, or hole blocking layer) may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

A device according to an embodiment may have a normal structure (e.g., not an inverted structure). In an embodiment, in the device, the first electrode 10 disposed on the transparent substrate 100 may include a metal oxide-based (i.e., metal oxide-containing) transparent electrode (e.g., an ITO electrode), and the second electrode 50 facing the first electrode may include a conductive metal (e.g., having a relatively low work function, Mg, Al, etc.). The hole auxiliary layer 20 (e.g., a hole injection layer such as PEDOT:PSS (poly(3,4-ethylenedioxythiophene): polystyrene sulfonate) and/or p-type metal oxide and/or a hole transport layer such as TFB (poly(9,9-dioctyl-fluorene-co-N-(4)-butylphenyl)-diphenylamine)) and/or PVK (poly(N-vinylcarbazole))) may be provided between the first (e.g., transparent) electrode 10 and the light emitting layer 30. The hole injection layer may be disposed close to the first (e.g., transparent) electrode and the hole transport layer may be disposed close to the light emitting layer. An electron auxiliary layer 40 such as an electron injection/transport layer may be disposed between the light emitting layer 30 and the second electrode 50. (Refer to FIG. 1B)

A device according to another embodiment may have an inverted structure. As used herein, the second electrode 50 disposed on the transparent substrate 100 may include a metal oxide-based transparent electrode (e.g., ITO), and the first electrode 10 facing the second electrode may include a metal (e.g., having a relatively high work function, Au, Ag, etc.). For example, an (optionally doped) n-type metal oxide (crystalline Zn metal oxide) or the like may be disposed as an electron auxiliary layer 40 (e.g., an electron transport layer) between the second (e.g., transparent) electrode 50 and the light emitting layer 30. MoOs or other p-type metal oxide may be disposed as a hole auxiliary layer 20 (e.g., a hole transport layer including TFB and/or PVK and/or a hole injection layer including MoOs or other p-type metal oxide) between the metal first electrode 10 and the light emitting layer 30. (Refer to FIG. 1C)

The aforementioned device may be manufactured by an appropriate method. For example, the electroluminescent device may be manufactured by optionally forming a hole auxiliary layer (e.g., by deposition or coating) on a substrate on which an electrode is disposed, forming a light emitting layer including nanoparticles (e.g., a pattern of the aforementioned nanoparticles), and forming (optionally, an electron auxiliary layer and) an electrode (e.g., by vapor deposition or coating) on the light emitting layer. A method of forming the electrode/hole auxiliary layer/electron auxiliary layer may be appropriately selected and is not particularly limited.

In an embodiment, the display device may include a first pixel and a second pixel configured to emit light of a color different from that of the first pixel. An electroluminescent device according to an embodiment may be disposed in the first pixel, the second pixel, or a combination thereof.

In another embodiment, the display device includes a light source (or light emitting panel) and a photo-color conversion element (or color conversion panel), wherein the photo-color conversion element (or color conversion panel) includes a light emitting layer, and the light emitting layer includes a film or a patterned film of a nanocrystal particle-polymer composite. The light emitting layer may be disposed on a (e.g., transparent) substrate. The light source is configured to provide incident light to the photo-color conversion element. The incident light may have an emission peak wavelength in a range of greater than or equal to about 440 nm, for example, greater than or equal to about 450 nm and less than or equal to about 560 nm, less than or equal to about 500 nm, less than or equal to about 480 nm, less than or equal to about 470 nm, or less than or equal to about 460 nm.

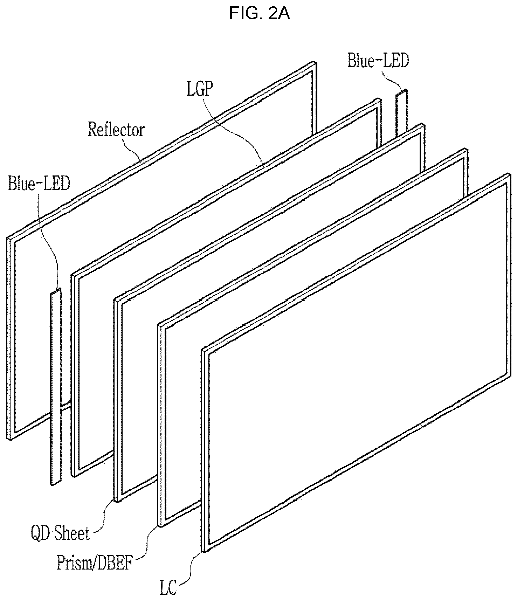

In an embodiment, the color conversion element may include a sheet of the quantum dot-polymer composite. The display device may further include a liquid crystal panel and the sheet of the quantum dot-polymer composite may be disposed between the light source and the liquid crystal panel. FIG. 2A shows an exploded view of a non-limiting display device. Referring to FIG. 2A, the display device may have a structure wherein a reflector, a light guide panel (LGP) and a blue LED light source (blue-LED), the quantum dot-polymer composite sheet (QD sheet), for example, various optical films such as a prism, double brightness enhance film (DBEF), and the like are stacked, and a liquid crystal panel (LC) is disposed thereon. The liquid crystal panel is disposed on the backlight unit and may have a structure including a liquid crystal and a color filter between two polarizers (Pol). The quantum dot-polymer composite sheet (QD sheet) may include quantum dots that emit red light and quantum dots that emit green light by absorbing light from a light source. Blue light provided from the light source may be converted into white light by being combined with red light and green light emitted from the quantum dots while passing through the quantum dot-polymer composite sheet. The white light may be separated into blue light, green light, and red light by the color filter in the liquid crystal panel, and may be emitted to the outside for each pixel.

In the device of an embodiment, the light emitting layer may include a pattern of the nanocrystal particle-polymer composite. The pattern may include at least one repeating section to emit light of a predetermined wavelength. The pattern of the nanocrystal particle-polymer composite may include a first section emitting first light and/or a second section emitting second light. The pattern of the nanocrystal particle-polymer composite may be produced by a photolithography method or an inkjet method as described later.

The light source may be an element emitting excitation light. The excitation light may include blue light and, optionally, green light. The light source may include an LED. The light source may include an organic LED (OLED). The light source may include a micro LED. An optical element that blocks (e.g., reflects or absorbs) blue light (and optionally green light), for example a blue light (and optionally green light) blocking layer or a first optical filter as described later may be disposed on the front surface (light emitting surface) of the first section and the second section. When the light source includes a blue light emitting organic light emitting diode and a green light emitting organic light emitting diode, a green light removing filter may be further disposed on the third section through which the blue light passes.

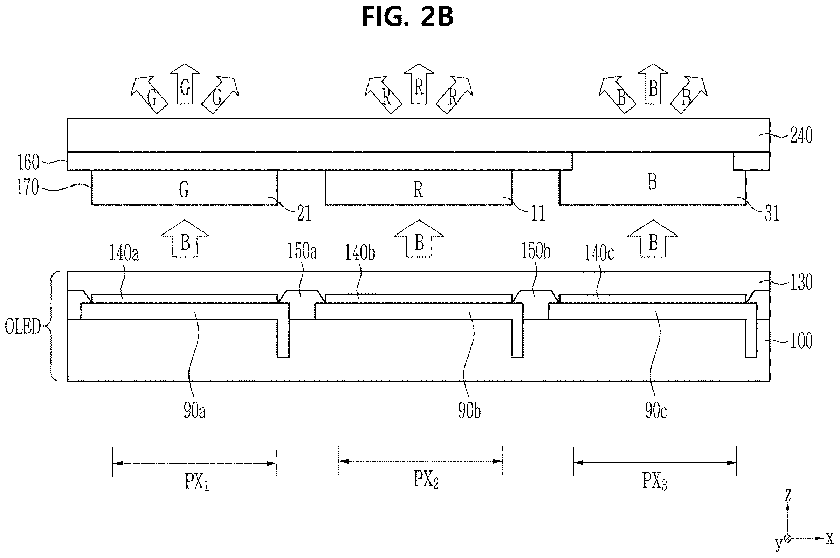

FIG. 2B is a schematic cross-sectional view of a device (or a display panel) having three (sub) pixels ($PX_1$, $PX_2$, $PX_3$) according to an embodiment. Referring to FIG. 2B, the light source (or light emitting panel) may include an organic light emitting diode emitting blue light (and optionally green light). The organic light emitting diode may include two or more pixel electrodes 90a, 90b, 90c formed on a substrate 100, a pixel defining layer 150a, 150b formed between adjacent pixel electrodes, 90a, 90b, 90c, an organic light emitting layer 140a, 140b, 140c formed on each pixel electrode 90a, 90b, 90c, and a common electrode layer 130 formed on the organic light emitting layer 140a, 140b, 140c. A thin film transistor (TFT) and a substrate may be disposed under the organic light emitting diode (OLED). The pixel area of the OLED may be disposed to correspond to first, second, and third sections to be described later. Although the color conversion panel and the light emitting panel are shown in a separate form in FIG. 2B, the color conversion panel may be stacked directly on the light emitting panel.

A laminated structure including the nanocrystal particle composite pattern 170 (e.g., a first region 11 or R including red light emitting nanocrystal particle, a second region 21 or G including green light emitting nanocrystal particle, and a third region 31 or B including or not including a nanocrystal particle, e.g., a blue light emitting nanocrystal particle) and substrate 240 may be disposed on the light source. The blue light emitted from the light source enters the first region and second region and may emit a red light and a green light, respectively. The blue light emitted from the light source may pass through the third region. An element (a first optical filter 160 or excitation light blocking layer) configured to block the excitation light may be disposed between the nanocrystal particle composite layers R and G and the substrate, if desired. In an embodiment, the excitation light includes a blue light and a green light, and a green light blocking filter (not shown) may be added to the third region. The first optical filter or the excitation light blocking layer will be described in more detail herein.

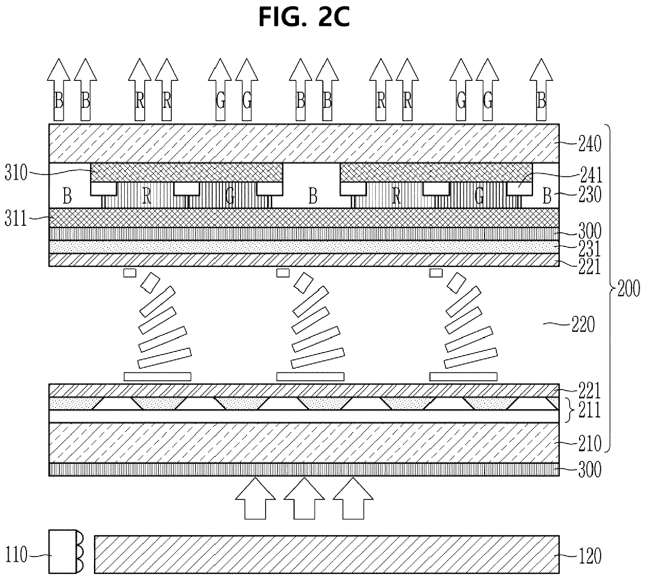

Non-limiting examples of the display device (e.g., a liquid crystal display device) according to an embodiment are illustrated with reference to the drawing. FIG. 2C is a schematic cross-sectional view showing a liquid crystal display according to an embodiment. Referring to FIG. 2C, the display device of an embodiment includes a liquid crystal panel 200, a polarizing plate 300 disposed under the liquid crystal panel 200, and a backlight unit (BLU) disposed under the polarizing plate 300.

The liquid crystal panel 200 includes a lower substrate 210, a stacked structure, and a liquid crystal layer 220 disposed between the stacked structure and the lower substrate. The stacked structure includes a transparent substrate 240 and a photoluminescent layer 230 including a pattern of a nanocrystal particle-polymer composite.

The lower substrate 210 that is also referred to as an array substrate may be a transparent insulating material substrate. The substrate is the same as described above. A wire plate 211 is provided on an upper surface of the lower substrate 210. The wire plate 211 may include a plurality of gate wires (not shown) and data wires (not shown) that define a pixel area, a thin film transistor disposed adjacent to a crossing region of gate wires and data wires, and a pixel electrode for each pixel area, but is not limited thereto. Details of such a wire plate are known and are not particularly limited.

The liquid crystal layer 220 may be disposed on the wire plate 211. The liquid crystal layer 220 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal material and the alignment layer are known and are not particularly limited.

A lower polarizing plate 300 is provided under the lower substrate. Materials and structures of the polarizing plate 300 are known and are not particularly limited. A backlight unit (e.g., emitting blue light) may be disposed under the polarizing plate 300. An upper optical element or an upper polarizing plate 300 may be provided between the liquid crystal layer 220 and the transparent substrate 240, but is not limited thereto. For example, the upper polarizing plate may be disposed between the liquid crystal layer 220 and the photoluminescent layer 230. The polarizing plate may be any polarizer that used in a liquid crystal display device. The polarizing plate may be TAC (triacetyl cellulose) having a thickness of less than or equal to about 200 $\mu$m, but is not limited thereto. In another embodiment, the upper optical element may be a coating that controls a refractive index without a polarization function.

The backlight unit includes a light source 110. The light source may emit blue light or white light. The light source may include a blue LED, a white LED, a white OLED, or a combination thereof, but is not limited thereto.

The backlight unit may further include a light guide panel 120. In an embodiment, the backlight unit may be an edge-type lighting. For example, the backlight unit may include a reflector (not shown), a light guide panel (not shown) provided on the reflector and providing a planar light source with the liquid crystal panel 200, and/or at least one optical sheet (not shown) on the light guide panel, for example, a diffusion plate, a prism sheet, and the like, but is not limited thereto. The backlight unit may not include a light guide panel. In an embodiment, the backlight unit may be a direct lighting. For example, the backlight unit may have a reflector (not shown), and may have a plurality of fluorescent lamps disposed on the reflector at regular intervals, or may have an LED operating substrate on which a plurality of light emitting diodes may be disposed, a diffusion plate thereon, and optionally at least one optical sheet. Details (e.g., each component of a light emitting diode, a fluorescent lamp, light guide panel, various optical sheets, and a reflector) of such a backlight unit are known and are not particularly limited.

A black matrix 241 is provided under the transparent substrate 240 and the black matrix 241 has openings and hides a gate line, a data line, and a thin film transistor of the wire plate on the lower substrate. For example, the black matrix 241 may have a lattice shape. The photoluminescent layer 230 is provided in the openings of the black matrix 241 and has a nanoparticle-polymer composite pattern including a first section (R) configured to emit first light (e.g., red light), a second section (G) configured to emit second light (e.g., green light), and a third section (B) configured to emit/transmit, for example blue light. If needed, the photoluminescent layer may further include at least one fourth section. The fourth section may include nanocrystal particle that emit different color from light emitted from the first to third sections (e.g., cyan, magenta, and yellow light).

In the photoluminescent layer 230, sections forming a pattern may be repeated corresponding to pixel areas formed on the lower substrate. A transparent common electrode 231 may be provided on the photoluminescent layer 230.

The third section (B) configured to emit/transmit blue light may be a transparent color filter that does not change an emission spectrum of the light source. In this case, blue light emitted from the backlight unit may enter in a polarized state and may be emitted through the polarizing plate and the liquid crystal layer as it is. If needed, the third section may include nanocrystal particle emitting blue light.

As described above, if desired, the display device or the light emitting device according to an embodiment may further include an excitation light blocking layer or a first optical filter layer (hereinafter, referred to as a first optical filter layer, 310). The first optical filter layer may be disposed between the bottom surfaces of the first section (R) and the second section (G) and the substrate (e.g., the upper substrate 240) or on the upper surface of the substrate. The first optical filter layer may be a sheet having an opening in a portion corresponding to a pixel area (third section) displaying blue, and may be formed in portions corresponding to the first and second sections. That is, the first optical filter layer may be integrally formed at portions other than the portion overlapping the third section as shown in FIGS. 2A and 2B, but the present disclosure is not limited thereto. Two or more first optical filter layers may be spaced apart from each other at portions overlapping the first and second sections, and optionally, the third section. If the light source includes a green light emitting element, a green light blocking layer may be disposed on the third section.

The first optical filter layer may, for example, block light of some wavelength regions of the visible light region and transmit light of the remaining wavelength region, and for example, may block blue light (or green light) and transmit light other than blue light (or green light). The first optical filter layer may transmit, for example, green light, red light, and/or yellow light that is a mixture thereof. The first optical filter layer may transmit blue light and block green light, and may be disposed on the blue light emitting pixel.

The first optical filter layer may substantially block excitation light and transmit light in a desired wavelength region. The transmittance of the first optical filter layer for light in a desired wavelength region may be greater than or equal to about 70%, greater than or equal to about 80 %, greater than or equal to about 90%, or even 100%.

A first optical filter layer selectively transmitting red light may be disposed on the portion overlapped with the section emitting red light and the first optical filter layer selectively transmitting green light may be disposed on the portion overlapped with the section emitting green light, respectively. The first optical filter layer may include at least one of a first section that blocks (e.g., absorbs) blue light and red light, a first region that selectively transmits light in a predetermined range (e.g., greater than or equal to about 500 nm, greater than or equal to about 510 nm, or greater than or equal to about 515 nm and about less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm), and a second region that blocks (e.g., absorbs) blue light and green light, and selectively transmits light in a predetermined range (e.g., greater than or equal to about 600 nm, greater than or equal to about 610 nm, or greater than or equal to about 615 nm and less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm). When the light source emits blue and green mixed light, the first optical filter may further include a third region that selectively transmits blue light and blocks green light.

The display device may further include a second optical filter layer (e.g., a red/green or yellow light recycle layer) 311 disposed between the photoluminescent layer and the liquid crystal layer (e.g., the photoluminescent layer and the upper polarizing plate, e.g., polarizer), transmitting at least a portion of third light (excitation light), and reflecting a, e.g., at least one, part of the first light, part of the second light, or part of each of the first light and second light. The first light may be red light, the second light may be green light, and the third light may be blue light. For example, the second optical filter layer may transmit only the third light (B) in a blue light wavelength region having a wavelength region of less than or equal to about 500 nm and light in a wavelength region of greater than about 500 nm, which is green light (G), yellow light, red light (R), or the like, may be not passed through the second optical filter layer and reflected. The reflected green light and red light may pass through the first and second sections and to be emitted to the outside of the display device.

The first region may be disposed at a portion overlapped with the green light emitting section. The second region may be disposed at a portion overlapped with the red light emitting section. The third region may be disposed at a portion overlapped with the blue light emitting section.

The first region, the second region, and optionally the third region may be optically isolated. The first optical filter layer may contribute to improving color purity of a display device.

The display device or the electronic device may include a television, a virtual reality/augmented reality (VR/AR) device, a mobile terminal, a monitor, a notebook computer, a television, an electric sign board, a camera, or an electronic component.

Hereinafter, the embodiments are illustrated in more detail with reference to examples. However, they are exemplary embodiments of the present disclosure, and the present disclosure is not limited thereto.

**Examples**

**Analysis methods**

[1] UV-Vis Absorption Spectroscopy Analysis

An UV-Vis Absorption spectroscopy Analysis is performed using an Agilent Cary5000 spectrometer to obtain a UV-Visible absorption spectrum.

[2] Photoluminescence Analysis

A Photoluminescence (PL) spectroscopy analysis is performed using a Hitachi F-7000 spectrometer or Hamamatsu's Quantaurus-QY equipment (Quantaurus-QY Absolute PL quantum yield spectrophotometer C11347-11), referring to the manufacturer's manual.

[3] X-ray Photoelectron Spectroscopy (XPS)

XPS analysis is performed using X-ray photoelectron spectroscopy (manufacturer: Physical Electronics, model name: Quantum2000).

[4] Transmission Electron Microscope Analysis

Transmission electron micrographs of the produced nanocrystals are obtained using a UT F30 Tecnai electron microscope.

[5] X-ray diffraction (XRD) Analysis

XRD analysis is performed using a Philips XPert PRO instrument with a power of 3 kW.

Synthesis is performed in an inert gas atmosphere (under nitrogen flowing conditions) unless otherwise specified. Precursor content is molar content unless otherwise specified.

**Example 1**

In a reaction flask containing 6 mL of octadecene (ODE), gallium acetylacetonate (0.25 mmol) and sulfur powder in a molar ratio of 1:4 are put with 1.1 mL of tributylphosphine. The reaction flask is heated to 100 °C under vacuum, and an atmosphere inside the reaction flask is converted into argon.

The reaction flask is heated to 280 °C and maintained for predetermined time (2 minutes to 60 minutes). When the reaction is completed, acetone is added to the reaction solution rapidly cooled to room temperature and then, centrifuged. The precipitates are dispersed in an organic solvent, obtaining a gallium sulfide nanocrystal solution.

Subsequently, UV-Vis absorption spectroscopy and photoluminescence spectroscopy are performed with respect to the gallium sulfide nanocrystals. As a result, an absorption peak is slightly shifted toward red, as reaction time goes. The gallium sulfide nanocrystals obtained from the reaction of 2 minutes exhibit a maximum emission peak of about 400 nm, and gallium sulfide nanocrystals obtained from the reaction of 60 minutes exhibit a maximum emission peak of about 460 nm, which confirms that emission peak intensity of the gallium sulfide nanocrystals may vary over the reaction time.

Referring to the results, band-edge emission is about 400 nm and mid-gap emission is considered to be about 460 nm.

**Example 2-1**

In a reaction flask containing 6 mL of octadecene (ODE), 0.25 mmol of gallium acetylacetonate ($Ga(acac)_3$) and 1.5 mmol of sulfur powder are put with 1.1 mL of tributylphosphine. The reaction flask is heated to 100 °C under vacuum, and an atmosphere inside the reaction flask is converted into argon. The reaction flask is heated to 280 °C and maintained for 1 minute to synthesize gallium sulfide ($Ga_2S_3$) nanocrystal particles. Subsequently, the reaction flask is cooled to 230 °C, and zinc oleate (0.16 mmol) is added thereto and then, reacted for about 50 minutes, synthesizing $Ga_2S_3$ core/ZnS shell nanocrystal particles. Subsequently, 0.5 mmol of aluminum isopropoxide ($Al(IPA)_3$) is added thereto and then, reacted for 5 minutes. After the reaction, acetone is added to the reaction solution rapidly cooled to room temperature and then, centrifuged. The obtained precipitates are dispersed in an organic solvent, obtaining a solution of $Ga_2S_3$ core/ZnS shell/$Al_2O_3$ shell nanocrystal particles.

The nanocrystal particle is additionally passivated with an aluminum oxide and thus may exhibit increased photoluminescence quantum efficiency (PLQY). Dispersibility and optical stability thereof may be improved.

The produced gallium sulfide nanocrystal particle has an average size of about 2.8 nm. The produced $Ga_2S_3$/ZnS nanocrystal particle has an average size of about 4.2 nm. The produced $Ga_2S_3$/ZnS/$Al_2O_3$ nanocrystal particle has an average size of about 5.0 nm.

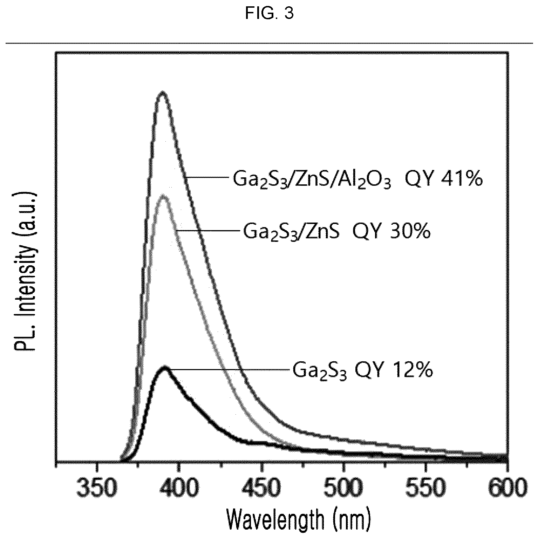

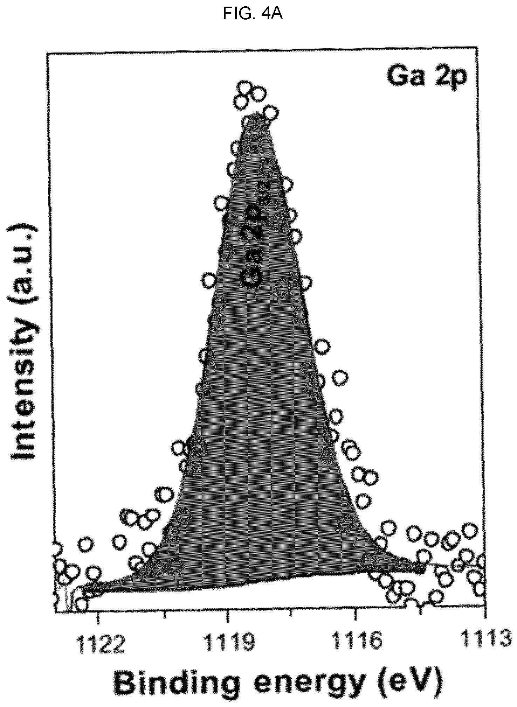

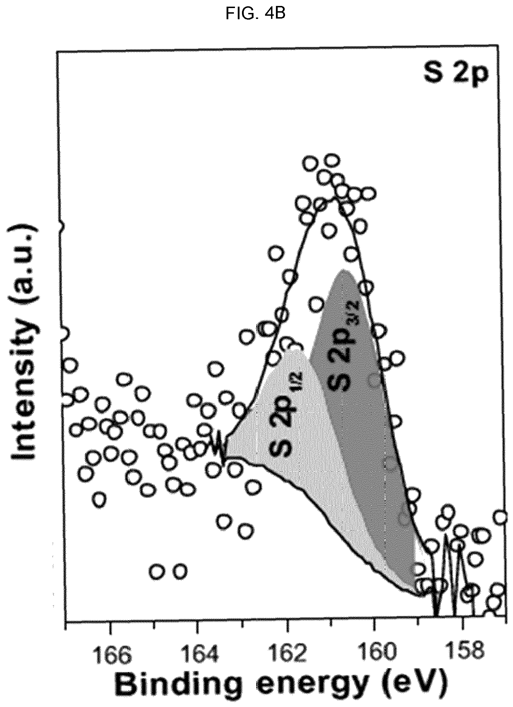

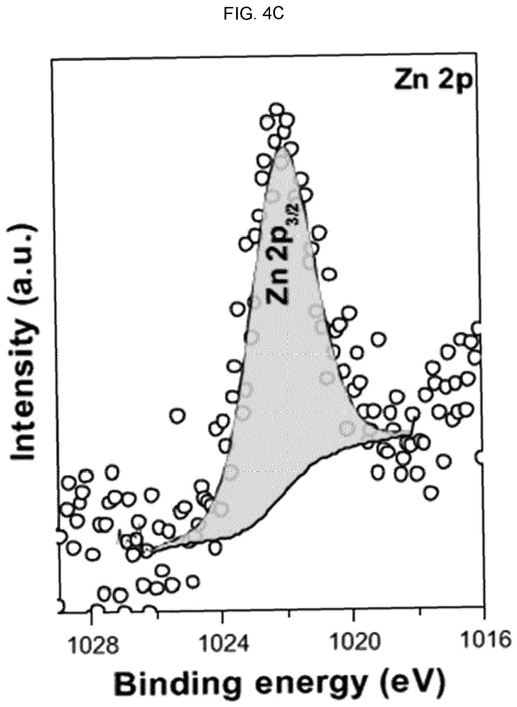

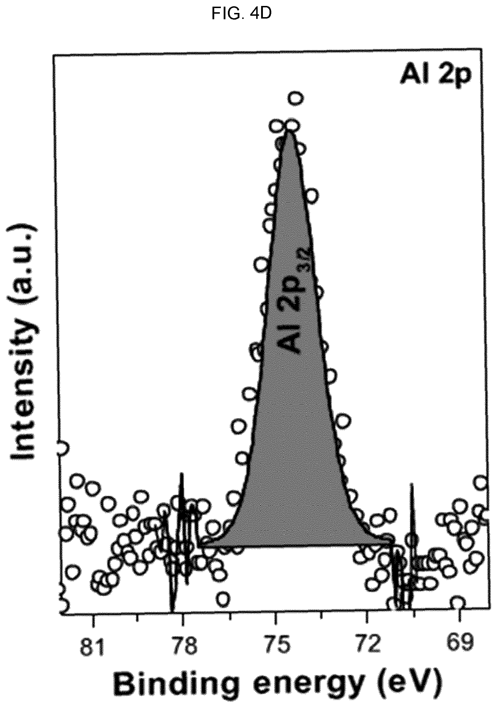

UV-Vis absorption spectroscopy, photoluminescence analysis, X-ray photoelectron spectroscopy, and X-ray diffraction analysis are performed with respect to the produced nanoparticle, and the results are shown in Tables 1 and 2 and FIGS. 3, 4A to 4D, 5, and 6.

Table 1

|  | Maximum photoluminescence peak wavelength | QY | Full width at half maximum (FWHM) (nm) | Average life-span (TRPL) |
|---|---|---|---|---|
| $Ga_2S_3$ | 400 nm | 12% | about 38 nm | 0.95 ns |
| $Ga_2S_3$/ZnS | 400 nm | 30% | 38 nm | 1.05 ns |
| $Ga_2S_3$/ZnS/$Al_2O_3$ | 400 nm | 41% | 38 nm | 1.5 ns |

Table 2

|  | Ga | S | Zn | Al |
|---|---|---|---|---|
| $Ga_2S_3$ | 1 | 1.8 | - | - |
| $Ga_2S_3$/ZnS | 1 | 2.42 | 0.15 | - |
| $Ga_2S_3$/ZnS/$Al_2O_3$ | 1 | 1.9 | 0.63 | 7.31 |

From the UV-Vis absorption spectroscopy analysis results, it was confirmed that the produced core/shell nanocrystal particle has a valley depth (VD) of greater than or equal to 0.5.

According to the photoluminescence spectroscopy results of FIG. 3, the produced particles may exhibit increased luminous efficiency and a relatively narrow full width at half maximum (FWHM).

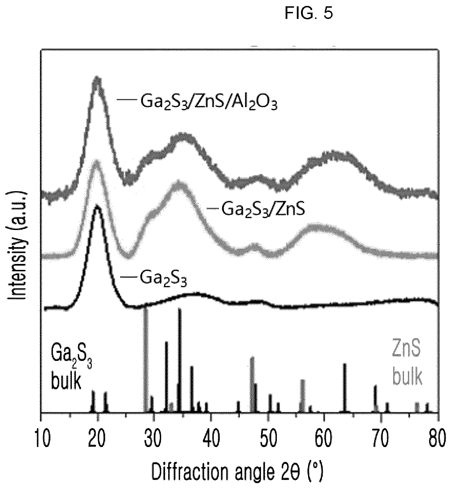

Referring to the XRD results, the produced nanocrystal particle has a first peak at a diffraction angle (2thata) within the range of 18 degrees to 22 degrees, wherein the first peak has a full width at half maximum (FWHM) of less than or equal to 10 degrees (e.g., less than or equal to 8 degrees or less than or equal to 6 degrees). From the XRD result of FIG. 5, it is confirmed that the produced nanocrystal particle has a monoclinic crystal structure.

The time-resolved photoluminescence spectroscopy (TRPL) results are more towards a single exponential curve by shell formation, suggesting that the trap level is reduced.

**Example 2-2**

$Ga_2S_3$ core/ZnS shell nanocrystal particle is synthesized in the same manner as in Example 2-1 except that the reaction time for forming gallium sulfide nanoparticle is increased to 30 minutes, and the aluminum oxide shell is not formed.

The $Ga_2S_3$ core has a PL emission wavelength of about 460 nm, and the ZnS shell formed thereon exhibited a shifted emission wavelength toward blue, which is in 400 nm to 410 nm.

**Example 3: Stability Evaluation**

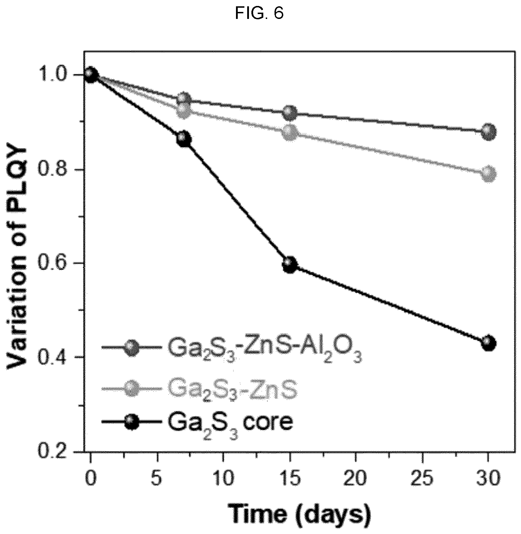

$Ga_2S_3$ nanoparticle, $Ga_2S_3$ /ZnS nanocrystal particle, and $Ga_2S_3$ /ZnS/$Al_2O_3$ nanocrystal particle are respectively synthesized in the same manner as in Example 2-1, allowed to stand in the ambient air for 30 days, and then, measured with respect to temporal variation of photoluminescence quantum efficiency (PLQY) normalized with respect to initial luminous efficiency, and the results are shown in FIG. 6.

Referring to the results of FIG. 6, stability of the nanocrystal particle may be improved by forming a ZnS shell or an aluminum oxide shell.

While this disclosure has been described in connection with what is presently considered to be practical example embodiments, it is to be understood that the invention is not limited to the disclosed embodiments. On the contrary, it is intended to cover various modifications and equivalent arrangements included within the scope of the appended claims.

**Claims**

1. A nanocrystal particle comprising:

   a Group III-VI compound comprising gallium and sulfur,
   wherein the nanocrystal particle is configured to emit a first light,
   a maximum emission peak wavelength of the first light is in a range of greater than or equal to 300 nanometers and less than or equal to 485 nanometers, and
   in the nanocrystal particle, a molar ratio of sulfur to gallium is greater than or equal to 1.8.

2. The nanocrystal particle of claim 1, wherein an absolute quantum efficiency of the nanocrystal particle is greater than or equal to 26%, and
   a full width at half maximum of the maximum emission peak of the first light is greater than or equal to 10 nanometers and less than or equal to 70 nanometers.

3. The nanocrystal particle of claims 1 or 2, wherein

   in the nanocrystal particle, a molar ratio of sulfur to gallium is greater than or equal to 1.85 and less than or equal to 4.5; and/or
   wherein the nanocrystal particle further comprises zinc, aluminum, or a combination thereof and preferably wherein in the nanocrystal particle, a molar ratio of zinc to gallium is greater than or equal to about 0.05:1.

4. The nanocrystal particle of any of claims 1-3, wherein

   the maximum emission peak wavelength of the first light is in a range of greater than or equal to 375 nanometers and less than or equal to 475 nanometers; and/or
   wherein the absolute quantum efficiency is greater than or equal to 40%, and optionally, wherein the maximum emission peak of the first light has a full width at half maximum of less than or equal to 50 nanometers.

5. The nanocrystal particle of any of claims 1-4, wherein

   the nanocrystal particle comprises a core and a shell on the core, and

a gallium content of the core is greater than a gallium content of the shell;
preferably wherein the shell comprises a zinc sulfide, an aluminum oxide, or a combination thereof;
preferably wherein the shell comprises
a first layer comprising the zinc sulfide, and
a second layer disposed on the first layer, the second layer comprising the aluminum oxide.

6. The nanocrystal particle of any of claims 1-5, wherein
in the nanocrystal particle, the molar ratio of the sulfur to the gallium is greater than or equal to 1.9 and less than or equal to 3.5.

7. The nanocrystal particle of any of claims 1-6, wherein

    the nanocrystal particle further comprises zinc, and
    a molar ratio of zinc to gallium in the nanocrystal particle is greater than or equal to 0.05 and less than or equal to 1.5.

8. The nanocrystal particle of any of claims 1-7, wherein

    the nanocrystal particle has a first peak at a diffraction angle, 2theta, of 15 degrees to 23 degrees, when analyzed by X-ray diffraction using $CuK\alpha$ radiation, and
    the first peak has a full width at half maximum of greater than or equal to 0.5 degree and less than or equal to 10 degrees.

9. The nanocrystal particle of any of claims 1-8, wherein the nanocrystal particle has a bandgap energy of greater than or equal to 2.6 electronvolts and less than or equal to 3.5 eV, when analyzed by ultraviolet-visible absorption spectroscopy; and/or
wherein
the nanocrystal particle has an average lifetime of greater than or equal to 0.5 nanosecond and of less than or equal to 50 nanoseconds, when analyzed by time-resolved photoluminescence spectroscopy.

10. The nanocrystal particle of any of claims 1-9, wherein when being left in the atmosphere for 7.5 days, the nanocrystal particle exhibit a quantum efficiency maintenance of greater than or equal to 90% of an initial quantum efficiency of the nanocrystal particle; and/or
wherein the nanocrystal particle has an average size of greater than or equal to 1 nanometer and less than or equal to 12 nanometers.

11. A light emitting device comprising the nanocrystal particle of any of claims 1-10.

12. A display device comprising the nanocrystal particle of any of claims 1-10.

13. A method of producing a nanocrystal particle of any of claims 1-10, the method comprising:

    contacting a gallium precursor, a sulfur precursor, and an additive in an organic solvent at a reaction temperature to provide a reaction system comprising gallium sulfide and produce the nanocrystal particle,
    wherein the reaction temperature is greater than 250 °C,
    wherein a content of the sulfur precursor per 1 mole of the gallium precursor is greater than or equal to 4 moles and less than or equal to 50 moles,

14. The method of claim 13, wherein
the sulfur precursor comprises a sulfur powder,
the additive comprises a compound represented by $R_3P$, wherein R is each independently hydrogen, or a substituted or unsubstituted C1 to C30 hydrocarbon group, and at least one R is a substituted or unsubstituted C1 to C30 hydrocarbon group, and
the organic solvent comprises a primary amine, a secondary amine, a tertiary amine, a nitrogen-containing heterocyclic compound, a substituted or unsubstituted $C_{4-50}$ aliphatic hydrocarbon solvent, a substituted or unsubstituted $C_{6-50}$ aromatic hydrocarbon solvent, a substituted or unsubstituted phosphine solvent, a substituted or unsubstituted phosphine oxide solvent, an aromatic ether solvent, or a combination thereof.

15. The method of claims 13 or 14, wherein
the method further comprises adding a zinc precursor, an aluminum precursor, or a combination thereof, to the reaction system comprising the gallium sulfide.

## FIG. 1A

## FIG. 1B

## FIG. 1C

FIG. 2A

# FIG. 2B

EP 4 375 347 A1

FIG. 2C

FIG. 3

FIG. 4A

FIG. 4B

FIG. 4C

FIG. 4D

FIG. 5

FIG. 6

Europäisches
Patentamt

European
Patent Office

Office européen
des brevets

# EUROPEAN SEARCH REPORT

Application Number

EP 23 21 1781

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZE MIN HU: "Synthesis and tunable emission of Ga2S3 quantum dots", MATERIALS LETTERS, vol. 239, 16 December 2018 (2018-12-16), pages 17-20, XP093152704, AMSTERDAM, NL ISSN: 0167-577X, DOI: 10.1016/j.matlet.2018.12.046 | 1,4,11, 12 | INV. C09K11/02 C09K11/56 C09K11/62 C09K11/64 H01L33/50 H10K50/115 |
| A | * table 1 * <br> * figure 3 * | 2,3, 5-10, 13-15 | |
| A | CN 109 385 272 A (HEFEI INST PHYSICAL SCI CAS) 26 February 2019 (2019-02-26) * claim 1 * * examples 1-5 * | 1-15 | |

-----

-----

TECHNICAL FIELDS
SEARCHED       (IPC)

C09K
H01L
H10K

The present search report has been drawn up for all claims

| Place of search | Date of completion of the search | Examiner |
|---|---|---|
| The Hague | 18 April 2024 | Poole, Robert |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons
........................................................................
& : member of the same patent family, corresponding
  document

EPO FORM 1503 03.82 (P04C01)

## ANNEX TO THE EUROPEAN SEARCH REPORT
## ON EUROPEAN PATENT APPLICATION NO.

**EP 23 21 1781**

This annex lists the patent family members relating to the patent documents cited in the above-mentioned European search report.
The members are as contained in the European Patent Office EDP file on
The European Patent Office is in no way liable for these particulars which are merely given for the purpose of information.

**18-04-2024**

| Patent document cited in search report | Publication date | Patent family member(s) | Publication date |
|---|---|---|---|
| CN 109385272 A | 26-02-2019 | NONE | |